# EUROPEAN PATENT APPLICATION

(11) **EP 4 210 038 A2**
(43) Date of publication of application: **12.07.2023**
(21) Application number: 23151017.3
(22) Date of filing: 10.01.2023
(51) Int. Cl.: G09G 3/3233

(54) **DISPLAY APPARATUS AND VEHICLE INCLUDING THE SAME**

(30) Priority: 11.01.2022 KR 20220004299
(71) Applicant: Samsung Display Co., Ltd., Yongin-si, Gyeonggi-do 17113 (KR)
(72) Inventor: KIM, Hyangyul, 17113 Yongin-si (KR); KIM, Jaehong, 17113 Yongin-si (KR); JUNG, Hyunho, 17113 Yongin-si (KR); JEONG, Heeseong, 17113 , Yongin-si (KR)
(74) Representative: Taor, Simon Edward William

(57) **Abstract**

A display apparatus includes: a first sub-pixel having a parallelogram shape including a first side extending in a first direction and a first width in a second direction perpendicular to the first direction; a second sub-pixel having a parallelogram shape including a second side extending in the first direction and a second width in the second direction; a third sub-pixel having a parallelogram shape including a third side extending in the first direction and a third width in the second direction; and a plurality of light-blocking lines extending in the first direction and spaced apart from each other with a first distance in the second direction, wherein each of the first width, the second width, and the third width is an integer multiple of the first distance.

## Description

### CROSS-REFERENCE TO RELATED APPLICATION(S)

This application claims priority to and benefits of Korean Patent Application No. 10-2022-0004299, filed on January 11, 2022, in the Korean Intellectual Property Office.

### BACKGROUND

### 1. Technical Field

Embodiments relate to a display apparatus and a vehicle including the display apparatus.

### 2. Description of the Related Art

Recently, display apparatuses have been used in various applications. For example, as display apparatuses have become thinner and lighter, their usage has gradually been extended, and as display apparatuses are being utilized in various fields, the demand for display apparatuses providing high-quality images has increased. Recently, display apparatuses have been provided inside vehicles to provide images to users sitting on a driver's seat or a passenger seat.

### SUMMARY

Light emitted from a display apparatus disposed inside a vehicle may be reflected by a front window glass or a side window glass of the vehicle and may reach a driver, and the driver may recognize that a screen provided by the display apparatus is formed on the front window glass or the side window glass. For example, the driver's vision may be hindered when driving the vehicle, and a safety issue may be caused when driving the vehicle.

Embodiments provide a display apparatus and a vehicle including the display apparatus. The display apparatus is capable of improving display quality and preventing the hinderance of a driver's vision by providing a plurality of light-blocking lines apart from each other with a preset distance.

Additional aspects will be set forth in part in the description which follows and, in part, will be apparent from the description, or may be learned by practice of the embodiments of the disclosure.

In an embodiment, a display apparatus may include a first sub-pixel having a parallelogram shape including a first side extending in a first direction and a first width in a second direction perpendicular to the first direction, a second sub-pixel having a parallelogram shape including a second side extending in the first direction and a second width in the second direction, a third sub-pixel having a parallelogram shape including a third side extending in the first direction and a third width in the second direction, and a plurality of light-blocking lines extending in the first direction and spaced apart from each other with a first distance in the second direction, wherein each of the first width, the second width, and the third width may be an integer multiple of the first distance.

Each of the first width, the second width, and the third width may be about three times of the first distance.

The first width may be substantially equal to the first distance, the second width may be about two times of the first distance, and the third width may be about three times of the first distance.

The display apparatus may further include a fourth sub-pixel having a parallelogram shape including a fourth side extending in the first direction and a fourth width in the second direction, wherein each of the first width and the third width may be substantially equal to the first distance, each of the second width and the fourth width may be about two times of the first distance, the first sub-pixel may emit light in a red wavelength band, the second sub-pixel may emit light in a green wavelength band, and each of the third sub-pixel and the fourth sub-pixel may emit light in a blue wavelength band.

An area of the second sub-pixel may be about 2.8 times of an area of the first sub-pixel, and an area of the third sub-pixel may be about 5.4 times of the area of the first sub-pixel.

Each of the first sub-pixel, the second sub-pixel, and the third sub-pixel may have a rectangular shape.

The display apparatus may further include a substrate including a display area and a non-display area, a display layer disposed in the display area and including a first organic light-emitting diode, a second organic light-emitting diode, and a third organic light-emitting diode, the first organic light-emitting diode including a first emission area corresponding to the first sub-pixel, the second organic light-emitting diode including a second emission area corresponding to the second sub-pixel, the third organic light-emitting diode including a third emission area corresponding to the third sub-pixel, an encapsulation member covering the display layer, an anti-reflection layer on the encapsulation member, and a light path-controlling layer on the anti-reflection layer and including the plurality of light-blocking lines.

The encapsulation member may include an encapsulation layer including at least one inorganic encapsulation layer and at least one organic encapsulation layer that are alternately stacked.

The first sub-pixel may include a plurality of first sub-pixels spaced apart from each other, and a second distance at which the plurality of first sub-pixels are disposed in the second direction may not be an integer multiple of the first distance.

In an embodiment, a display apparatus may include a first sub-pixel having a rhombus shape having vertexes spaced apart from each other in a first direction and a first width in a second direction perpendicular to the first direction, a second sub-pixel having a rhombus shape having vertexes spaced apart from each other in the first direction and a second width in the second direction, a third sub-pixel having a rhombus shape having vertexes spaced apart from each other in the first direction and a third width in the second direction, and a plurality of light-blocking lines extending in the first direction and spaced apart from each other with a first distance in the second direction, wherein each of the first width, the second width, and the third width may be an integer multiple of the first distance, and the integer multiple may be 2 or more.

In an embodiment, a vehicle may include side window glasses spaced apart from each other in a first direction, and a display apparatus disposed between the side window glasses, wherein the display apparatus includes a first sub-pixel having a parallelogram shape having a first width in a second direction perpendicular to the first direction, a second sub-pixel having a parallelogram shape having a second width in the second direction, a third sub-pixel having a parallelogram shape having a third width in the second direction, and a plurality of light-blocking lines extending in the first direction and spaced apart from each other with a first distance in the second direction, wherein each of the first width, the second width, and the third width may be an integer multiple of the first distance.

The first sub-pixel may have a first side extending in the first direction, the second sub-pixel may have a second side extending in the first direction, and the third sub-pixel may have a third side extending in the first direction.

Each of the first width, the second width, and the third width may be about three times of the first distance.

The first width may be substantially equal to the first distance, the second width may be about two times of the first distance, and the third width may be about three times of the first distance.

The display apparatus may further include a fourth sub-pixel having a parallelogram shape including a fourth side extending in the first direction and a fourth width in the second direction, wherein each of the first width and the third width may be substantially equal to the first distance, each of the second width and the fourth width may be about two times of the first distance, the first sub-pixel may emit light in a red wavelength band, the second sub-pixel may emit light in a green wavelength band, and each of the third sub-pixel and the fourth sub-pixel may emit light in a blue wavelength band.

An area of the second sub-pixel may be about 2.8 times of an area of the first sub-pixel, and an area of the third sub-pixel may be about 5.4 times of the area of the first sub-pixel.

Each of the first sub-pixel, the second sub-pixel, and the third sub-pixel may have a rectangular shape.

The display apparatus may further include a substrate including a display area and a non-display area, a display layer disposed in the display area and including a first organic light-emitting diode, a second organic light-emitting diode, and a third organic light-emitting diode, wherein the first organic light-emitting diode may include a first emission area corresponding to the first sub-pixel, the second organic light-emitting diode may include a second emission area corresponding to the second sub-pixel, and the third organic light-emitting diode may include a third emission area corresponding to the third sub-pixel, an encapsulation member covering the display layer, an anti-reflection layer on the encapsulation member, and a light-path controlling layer on the anti-reflection layer and including the plurality of light-blocking lines.

Each of the first sub-pixel, the second sub-pixel, and the third sub-pixel may have a rhombus shape having vertexes spaced apart from each other in the first direction, and the integer multiple may be 2 or more.

The first sub-pixel may include a plurality of first sub-pixels spaced apart from each other, and a second distance at which the plurality of first sub-pixels are arranged in the second direction may not be an integer multiple of the first distance.

According to an aspect, there is provided a display apparatus as set out in claim 1. Additional features are set out in claims 2 to 14.

According to an aspect, there is provided a vehicle as set out in claim 15.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of the exterior of a vehicle according to an embodiment;
FIGS. 2A and 2B are schematic views of the interior of a vehicle according to an embodiment;
FIG. 3 is a schematic perspective view of a display apparatus according to an embodiment;
FIGS. 4A and 4B are schematic cross-sectional views of the display apparatus of FIG. 3, taken along line A-A' in FIG. 3;
FIG. 5 is a schematic equivalent circuit diagram of a sub-pixel according to an embodiment;
FIG. 6 is a schematic plan view of a display apparatus according to an embodiment;
FIG. 7 is an enlarged view of a region B of the display apparatus of FIG. 6 according to an embodiment;
FIGS. 8A and 8B are schematic cross-sectional views of the display apparatus of FIG. 7, taken along line C-C' in FIG. 7;
FIG. 9 is an enlarged view of a region B of the display apparatus of FIG. 6 according to a comparative example;
FIG. 10A is a view showing brightness simulation results of the display apparatus of FIG. 7;
FIG. 10B is a view showing brightness simulation results of the display apparatus of FIG. 9;
FIG. 11 is an enlarged view of a region B of the display apparatus of FIG. 6 according to an embodiment;
FIG. 12 is an enlarged view of the region B of the display apparatus of FIG. 6 according to an embodiment;
FIG. 13 is a table showing simulation results according to embodiments and simulation results according to a comparative example;
FIG. 14 is an enlarged view of the region B of the display apparatus of FIG. 6 according to an embodiment;
FIG. 15 is an enlarged view of the region B of the display apparatus of FIG. 6 according to an embodiment;
FIG. 16 is an enlarged view of the region B of the display apparatus of FIG. 6 according to a comparative example;
FIG. 17 is a table showing simulation results according to embodiments and simulation results according to a comparative example;
FIG. 18 is an enlarged view of the display apparatus of FIG. 6 according to an embodiment;
FIG. 19 is an enlarged view of the region B of the display apparatus of FIG. 6 according to a comparative example; and
FIG. 20 is a table showing simulation results according to embodiments and simulation results according to a comparative example.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

Hereinafter, embodiments will be described with reference to the accompanying drawings, wherein like reference numerals refer to like elements throughout and a redundant description thereof is omitted for descriptive convenience.

While such terms as "first" and "second" may be used to describe various components, such components must not be limited to the above terms. The above terms are used to distinguish one component from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or components but do not preclude the addition of one or more other features or components.

It will be further understood that, when a layer, region, or component is referred to as being "on" another layer, region, or component, it can be directly or indirectly on the other layer, region, or component. For example, intervening layers, regions, or components may be present.

Sizes of elements in the drawings may be exaggerated or reduced for convenience of explanation. For example, since sizes and thicknesses of elements in the drawings are arbitrarily illustrated for convenience of explanation.

In the case where a certain embodiment may be implemented differently, a specific process order may be performed in the order different from the described order. As an example, two processes that are successively described may be substantially simultaneously performed or performed in the order opposite to the order described.

It will be understood that when a layer, region, or component is referred to as being "connected" to another layer, region, or component, it may be "directly connected" to the other layer, region, or component or may be "indirectly connected" to the other layer, region, or component with other layer, region, or component interposed therebetween. For example, it will be understood that when a layer, region, or component is referred to as being "electrically connected" to another layer, region, or component, it may be "directly electrically connected" to the other layer, region, or component or may be "indirectly electrically connected" to other layer, region, or component with other layer, region, or component interposed therebetween.

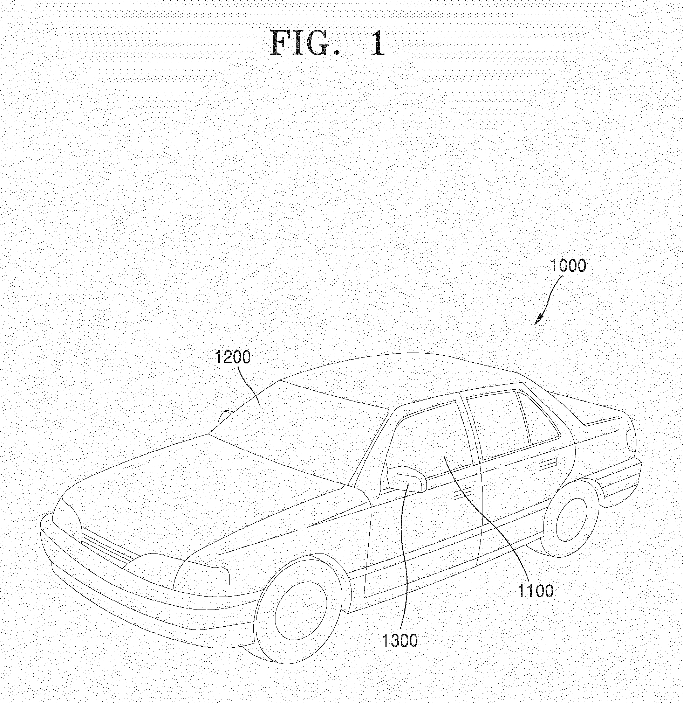

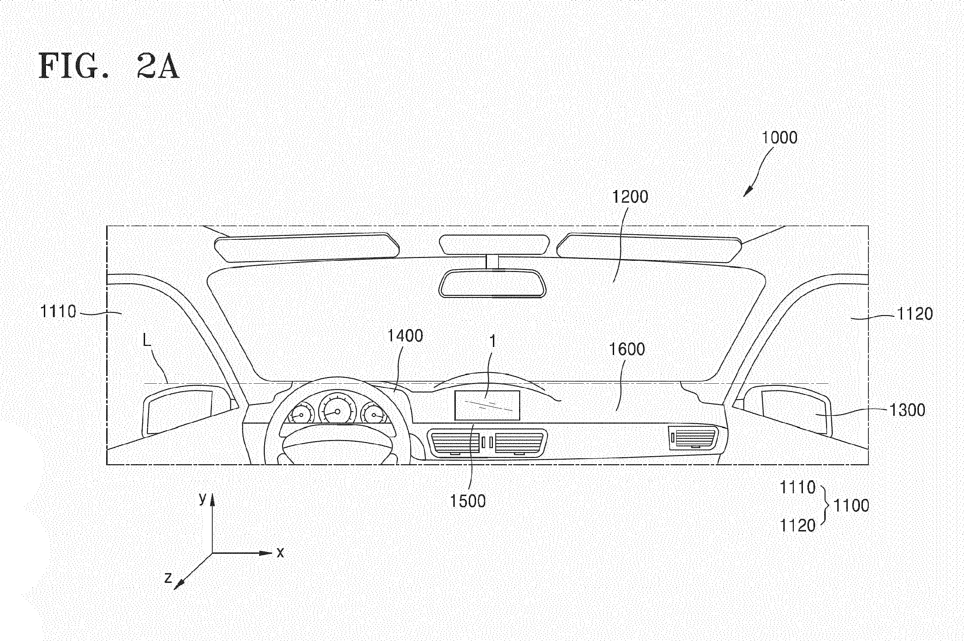

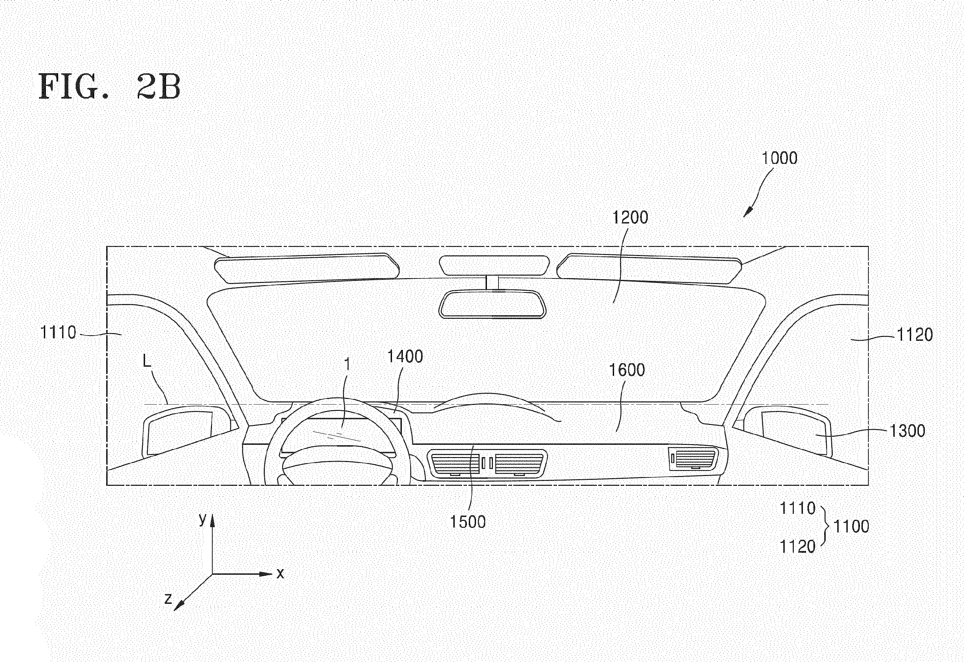

FIG. 1 is a schematic view of the exterior of a vehicle 1000 according to an embodiment. FIGS. 2A and 2B are schematic views of the interior of the vehicle 1000 according to an embodiment.

Referring to FIGS. 1, 2A and 2B, the vehicle 1000 may include various apparatuses that move (or transfer) an object such as human beings, things, animals, or the like from a departure point to a destination. The vehicle 1000 may include a vehicle traveling (or moving) on a road or track, a vessel moving (or sailing) over the sea or river, and an airplane flying in the sky using the action of air.

The vehicle 1000 may travel on a road or track. The vehicle 1000 may move in various directions (e.g., a preset direction) according to rotation of at least one wheel. As an example, the vehicle 1000 may include a three-wheeled or four-wheeled vehicle, a construction machine, a two-wheeled vehicle, a motor apparatus, a bicycle, and a train running on a track.

The vehicle 1000 may include a body and a chassis. For example, the body may have an interior and an exterior, and the chassis may be the rest of parts except for the body and in which mechanical apparatuses for driving are installed. The exterior of the body may include a front panel, a bonnet, a roof panel, a rear panel, a trunk, and a pillar disposed in a boundary between doors. The chassis of the vehicle 1000 may include a power generating device, a power transmitting device, a driving device, a steering device, a braking device, a suspension device, a transmission device, a fuel device, front, rear, left, and right wheels, and the like.

The vehicle 1000 may include a side window glass 1100, a front window glass 1200, a side mirror 1300, a cluster 1400, a center fascia 1500, a passenger seat dashboard 1600, and a display apparatus 1.

The side window glass 1100 and the front window glass 1200 may be partitioned (or defined) by a pillar disposed between the side window glass 1100 and the front window glass 1200.

The side window glass 1100 may be disposed in the lateral side of the vehicle 1000. In an embodiment, the side window glass 1100 may be disposed in the door of the vehicle 1000. The side window glass 1100 may be disposed in plurality and the plurality of side window glasses 1100 may face each other. In an embodiment, the side window glass 1100 may include a first side window glass 1110 and a second side window glass 1120. The first side window glass 1110 may be adjacent to the cluster 1400. The second side window glass 1120 may be adjacent to the passenger seat dashboard 1600.

The side window glasses 1100 may be spaced apart from each other in a first direction (e.g., an x direction). As an example, the first side window glass 1110 may be spaced apart from the second side window glass 1120 in the x direction. For example, a virtual connection line L connecting the side window glasses 1100 may extend in the first direction (e.g., the x direction).

The front window glass 1200 may be disposed on the front of the vehicle 1000. The front window glass 1200 may be disposed between the side window glasses 1100 facing each other.

The side mirror 1300 may provide a rear view of the vehicle 1000. The side mirror 1300 may be disposed on the exterior of the body. The side mirror 1300 may be provided in plurality. One of the plurality of side mirrors 1300 may be disposed on the outer side of the first side window glass 1110. Another of the plurality of side mirrors 1300 may be disposed on the outer side of the second side window glass 1120.

The cluster 1400 may be positioned in front of a steering wheel. A tachometer, a speedometer, a coolant thermometer, a fuel gauge, a turn indicator light, a high beam indicator light, a warning light, a seat belt warning light, an odometer, an automatic transmission lever position indicator light, a door open warning light, an engine oil warning light, and/or a low fuel warning light may be disposed in the cluster 1400.

The center fascia 1500 may include a control panel including a plurality of buttons for adjusting an audio device, an air conditioning device, and a heater of seats. The center fascia 1500 may be disposed on one side of the cluster 1400.

The passenger seat dashboard 1600 may be spaced apart from the cluster 1400 with the center fascia 1500 therebetween. In an embodiment, the cluster 1400 may be disposed to correspond to a driver seat, and the passenger seat dashboard 1600 may be disposed to correspond to a passenger seat. In an embodiment, the cluster 1400 may be adjacent to the first side window glass 1110, and the passenger seat dashboard 1600 may be adjacent to the second side window glass 1120.

The display apparatus 1 may be disposed inside the vehicle 1000. The display apparatus 1 may be disposed between the side window glasses 1100. The display apparatus 1 may display images. In an embodiment, the display apparatus 1 may be disposed in one of the cluster 1400, the center fascia 1500, and the passenger seat dashboard 1600.

The display apparatus 1 may include liquid crystal displays, electrophoretic displays, organic light-emitting displays, inorganic light-emitting displays, field emission displays, surface-conduction electron-emitter displays, quantum dot displays, plasma displays, cathode ray displays, and the like. Hereinafter, though an organic light-emitting display apparatus is described as an example of the display apparatus 1 according to an embodiment, the various types of display apparatuses described above may be used in (or applied to) embodiments.

Referring to FIG. 2A, the display apparatus 1 may be disposed in the center fascia 1500. In an embodiment, the display apparatus 1 may display navigation information. In an embodiment, the display apparatus 1 may display information regarding audio, video, or vehicle settings.

Light emitted from the display apparatus 1 may transmit in various direction (e.g., a specific direction). As an example, light emitted from the display apparatus 1 may transmit toward the driver seat. Light emitted from the display apparatus 1 may transmit toward the passenger seat. Light emitted from the display apparatus 1 may not transmit to the front window glass 1200. In another example, light emitted from the display apparatus 1 may transmit to the front window glass 1200 at a relatively small ratio. In the case where light emitted from the display apparatus 1 transmits toward the front window glass 1200, the light emitted from the display apparatus 1 may be reflected by the front window glass 1200 to reach the driver seat. Accordingly, the driver may recognize images of the display apparatus 1 focused on the front window glass 1200, and may not recognize an object in the front direction, and thus, may not be safe when driving. In the present embodiment, light emitted from the display apparatus 1 disposed in the center fascia 1500 may transmit in various direction (e.g., a specific direction). Accordingly, light transmitting toward the front window glass 1200 may be reduced.

Referring to FIG. 2B, the display apparatus 1 may be disposed in the cluster 1400. For example, the cluster 1400 may be configured to display driving information and the like by using the display apparatus 1. For example, the cluster 1400 may be implemented digitally. The digital cluster 1400 may display vehicle information and driving information by using images. As an example, a needle of a tachometer and a gauge, and various warning light icons may be displayed by using digital signals.

Light emitted from the display apparatus 1 may transmit in various direction (e.g., a specific direction). As an example, light emitted from the display apparatus 1 may transmit toward the driver seat. Light emitted from the display apparatus 1 may not transmit to the front window glass 1200. In another example, light emitted from the display apparatus 1 may transmit to the front window glass 1200 at a relatively small ratio. In the case where light emitted from the display apparatus 1 transmits toward the front window glass 1200, the light emitted from the display apparatus 1 may be reflected by the front window glass 1200 to reach the driver seat. Accordingly, the driver may recognize images of the display apparatus 1 focused on the front window glass 1200, and a safety issue may be caused when driving. In contrast, according to the present embodiment, light emitted from the display apparatus 1 disposed in the cluster 1400 may transmit in various direction (e.g., a specific direction). Accordingly, light transmitting toward the front window glass 1200 may be reduced.

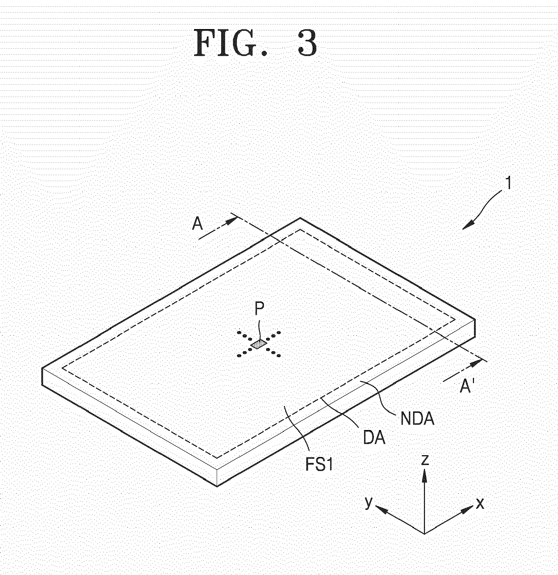

FIG. 3 is a schematic perspective view of the display apparatus 1 according to an embodiment.

Referring to FIG. 3, the display apparatus 1 may include a display area DA and a non-display area NDA. A sub-pixel P may be arranged in the display area DA. In an embodiment, a sub-pixel P may be disposed on a front surface FS1 of the display apparatus 1.

A plurality of sub-pixels P may be arranged in the display area DA. A sub-pixel P may be implemented by using a light-emitting element. Light emitted from the sub-pixel P may transmit in one direction from the front surface FS1 of the display apparatus 1. Light emitted from the sub-pixel P may not transmit in another direction from the front surface FS1 of the display apparatus 1. In an embodiment, light emitted from the sub-pixel P may transmit in a direction (e.g., a z direction) perpendicular to the front surface FS1 of the display apparatus 1. Light emitted from the sub-pixel P may transmit in a direction (e.g., a direction intersecting the z direction) oblique to the front surface FS1 of the display apparatus 1. In an embodiment, light emitted from the sub-pixel P may not have a component of at least one of the first direction (e.g., the x direction) and a second direction (e.g., a y direction).

The sub-pixel P may emit red light, green light, or blue light by using a light-emitting element. In an embodiment, the sub-pixel P may emit red light, green light, blue light, or white light by using a light-emitting element. The sub-pixel P may be defined by an emission area of a light-emitting element that emits at least one of red light, green light, blue light, and white light.

The sub-pixel P may include a light-emitting diode as a light-emitting element that may emit light of a color (e.g., a preset color). The light-emitting diode may include an organic light-emitting diode including an organic material as an emission layer. In another example, the light-emitting diode may include an inorganic light-emitting diode. In another example, the light-emitting diode may include quantum dots as an emission layer. In an embodiment, the size of the light-emitting diode may be microscale or nanoscale. As an example, the light-emitting diode may be a micro light-emitting diode. In another example, the light-emitting diode may be a nano light-emitting diode. The nano light-emitting diode may include gallium nitride (GaN). In an embodiment, a color-converting layer may be arranged on the nano light-emitting diode. The color-converting layer may include quantum dots. Hereinafter, for convenience of description, the case where the light-emitting diode includes an organic light-emitting diode is described in detail.

The non-display area NDA may be a region that does not display images. The non-display area NDA may surround at least a portion of the display area DA. In an embodiment, the non-display area NDA may surround the display area DA entirely (or partially). A driver and the like configured to provide electric signals or power to the sub-pixel P may be arranged in the non-display area NDA. The non-display area NDA may include a pad area in which a pad is arranged.

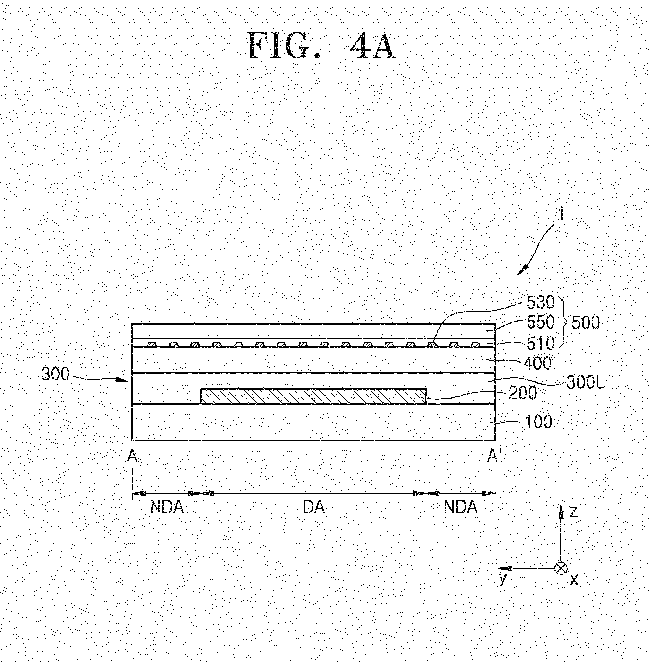

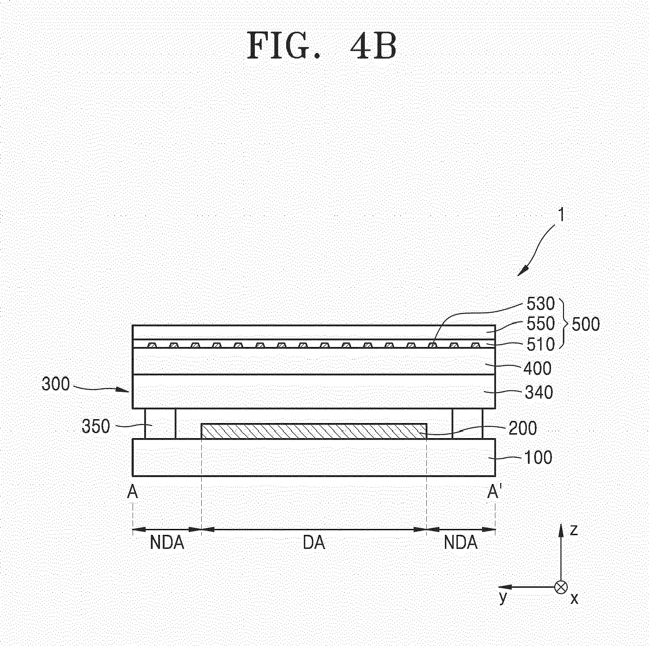

FIGS. 4A and 4B are schematic cross-sectional views of the display apparatus 1 of FIG. 3, taken along line A-A'.

Referring to FIGS. 4A and 4B, the display apparatus 1 may include a substrate 100, a display layer 200, an encapsulation member 300, an anti-reflection layer 400, and a light path-controlling layer 500. The substrate 100 may include glass or a polymer resin such as polyethersulfone, polyarylate, polyetherimide, polyethylene naphthalate, polyethylene terephthalate, polyphenylene sulfide, polyimide, polycarbonate, cellulose tri acetate, cellulose acetate propionate, and the like. In an embodiment, the substrate 100 may have a multi-layered structure including a base layer and a barrier layer each including the polymer resin. The substrate 100 including the polymer resin is flexible, rollable, and bendable.

The display layer 200 may be arranged on the substrate 100. The display layer 200 may include a pixel circuit layer and a light-emitting element layer. The pixel circuit layer may include a pixel circuit. The pixel circuit may include a transistor and a storage capacitor. The light-emitting element layer may include a light-emitting element connected to the pixel circuit.

Referring to FIG. 4A, the encapsulation member 300 may include an encapsulation layer 300L. The encapsulation layer 300L may include at least one inorganic encapsulation layer and at least one organic encapsulation layer. The at least one inorganic encapsulation layer and the at least one organic encapsulation layer may be stacked in turns. The at least one inorganic encapsulation layer may include at least one inorganic material among aluminum oxide (Al₂O₃), titanium oxide (TiO₂), tantalum oxide (Ta₂O₅), zinc oxide (ZnOₓ), silicon oxide (SiOx), silicon nitride (SiNₓ), and silicon oxynitride (SiON). Zinc oxide (ZnOₓ) may be zinc oxide (ZnO) and/or zinc peroxide (ZnO₂). The at least one organic encapsulation layer may include a polymer-based material. The polymer-based material may include an acryl-based resin, an epoxy-based resin, polyimide, and polyethylene. In an embodiment, the at least one organic encapsulation layer may include acrylate.

Referring to FIG. 4B, the encapsulation member 300 may include an encapsulation substrate 340 and a sealing member 350. The encapsulation substrate 340 may be disposed on the display layer 200. The sealing member 350 may be disposed between the substrate 100 and the encapsulation substrate 340 in the non-display area NDA. An inner space between the display layer 200 and the encapsulation substrate 340 may be sealed. The sealing member 350 may be sealant. In another example, the sealing member 350 may include a material hardened by a laser beam. As an example, the sealing member 350 may include frit. For example, the sealing member 350 may include an organic sealant such as a urethane-based resin, an epoxy-based resin, an acrylic resin, or an inorganic sealant. In an embodiment, the sealing member 350 may include silicone. For example, a urethane-based rein may include urethane acrylate and the like. For example, an acrylic resin may include butyl acrylate, ethylhexyl acrylate, and the like. The sealing member 350 may include a material hardened by heat.

Referring to FIGS. 4A and 4B, the anti-reflection layer 400 may be disposed on the encapsulation member 300. The anti-reflection layer 400 may reduce reflectivity of light (e.g., external light) incident toward the display apparatus 1 from outside. In an embodiment, the anti-reflection layer 400 may include a retarder and/or a polarizer. The retarder may include a film-type retarder or a liquid crystal-type retarder. The retarder may include a λ/2 retarder and/or a λ/4 retarder. The polarizer may include a film-type polarizer or a liquid crystal-type polarizer. The film-type polarizer may include a stretchable synthetic resin film, and the liquid crystal-type polarizer may include liquid crystals arranged in an arrangement (e.g., a predetermined arrangement). Each of the retarder and the polarizer may further include a protective film.

In another example, the anti-reflection layer 400 may include a black matrix and color filters. The color filters may be arranged according to colors of lights emitted respectively from the light-emitting elements of the display apparatus 1. The color filters may each include red, green, or blue pigment or dye. In another example, the color filters may each further include quantum dots in addition to the pigment or dye. In another example, some of the color filters may not include the pigment or dye and may include scattering particles such as titanium oxide.

In another example, the anti-reflection layer 400 may include a destructive interference structure. The destructive interference structure may include a first reflection layer and a second reflection layer respectively arranged on different layers. First-reflected light and second-reflected light respectively reflected by the first reflection layer and the second reflection layer may destructively interfere and thus the reflectivity of external light may be reduced.

The light path-controlling layer 500 may be disposed on the anti-reflection layer 400. In an embodiment, an adhesive layer may be disposed between the light path-controlling layer 500 and the anti-reflection layer 400. The light path-controlling layer 500 may be configured to control a transmission direction of light emitted from the display layer 200. As an example, a component in the second direction (e.g., the y direction) of light emitted from the display layer 200 may be at least partially removed by the light path-controlling layer 500. The light path-controlling layer 500 may include a first layer 510, a plurality of light-blocking lines 530, and a second layer 550. The first layer 510 may include a transparent resin. In an embodiment, the first layer 510 may include a plurality of grooves. The plurality of grooves may be arranged with a constant distance.

The plurality of light-blocking lines 530 may fill the plurality of grooves, respectively. The plurality of light-blocking lines 530 may each include a light-blocking material. As an example, the plurality of light-blocking lines 530 may include a black material. The plurality of light-blocking lines 530 may be formed by filling the plurality of grooves with black ink, respectively, and then irradiating ultraviolet light. The plurality of light-blocking lines 530 may extend in the first direction (e.g., the x direction). The plurality of light-blocking lines 530 may be spaced apart from each other in the second direction (e.g., the y direction) perpendicular to the first direction (e.g., the x direction).

The second layer 550 may be disposed on the first layer 510 and the plurality of light-blocking lines 530. The second layer 550 may include a polymer resin. As an example, the second layer 550 may include polycarbonate.

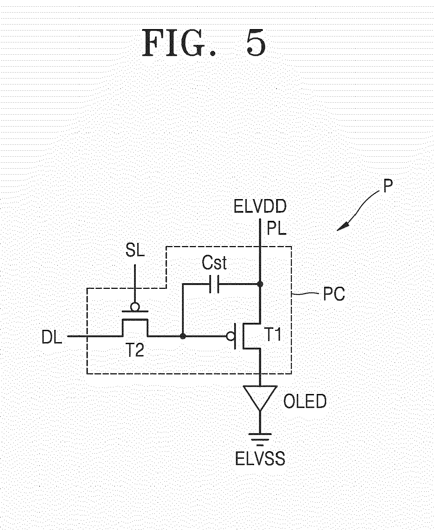

FIG. 5 is a schematic equivalent circuit diagram of a sub-pixel P according to an embodiment.

Referring to FIG. 5, the sub-pixel P may include a pixel circuit PC and an organic light-emitting diode OLED as a light-emitting element. The pixel circuit PC may include a driving transistor T1 (e.g., a driving thin-film transistor), a switching transistor T2 (e.g., a switching thin-film transistor), and a storage capacitor Cst. The sub-pixel P may emit, for example, red light, green light, or blue light, or emit red light, green light, blue light, or white light by using the organic light-emitting diode OLED.

The switching transistor T2 may be connected to a scan line SL and a data line DL, and configured to transfer a data voltage or a data signal to the driving transistor T1 according to a switching voltage or a switching signal input from the scan line SL, the data voltage or the data signal being input from the data line DL. The storage capacitor Cst may be connected to the switching transistor T2 and a driving voltage line PL and configured to store a voltage corresponding to a difference between a voltage transferred from the switching transistor T2 and a first power voltage ELVDD supplied to the driving voltage line PL.

The driving transistor T1 may be connected to the driving voltage line PL and the storage capacitor Cst and configured to control a driving current according to the voltage stored in the storage capacitor Cst, the driving current flowing from the driving voltage line PL to the organic light-emitting diode OLED. The organic light-emitting diode OLED may emit light having a brightness (e.g., a preset brightness) corresponding to the driving current. The common electrode (e.g., a cathode) of the organic light-emitting diode OLED may receive a second power voltage ELVSS.

Though it is shown in FIG. 5 that the pixel circuit PC includes two transistors and one storage capacitor, the pixel circuit PC may include three or more transistors.

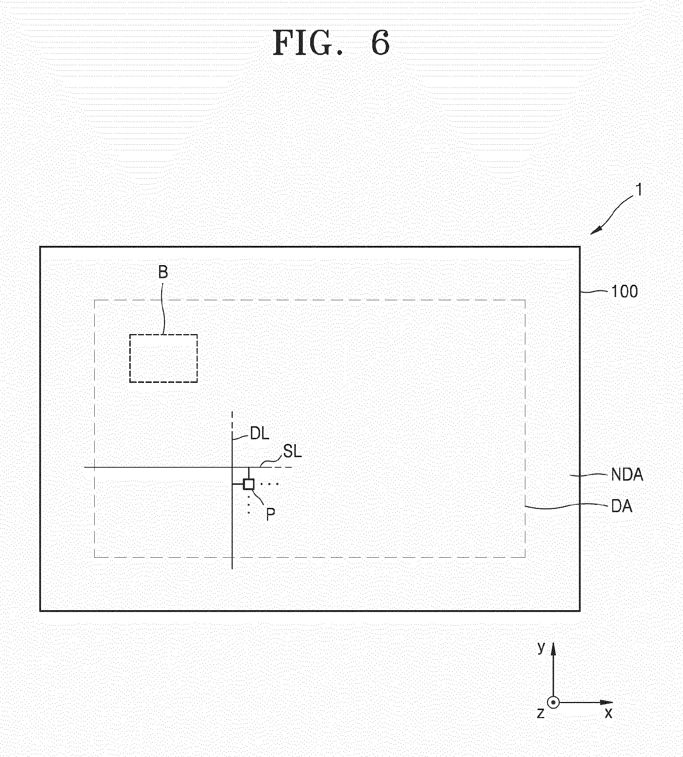

FIG. 6 is a schematic plan view of the display apparatus 1 according to an embodiment.

Referring to FIG. 6, the display apparatus 1 may include the display area DA and the non-display area NDA. The display apparatus 1 may include the substrate 100 and a multi-layer on the substrate 100. The display area DA and the non-display area NDA may be defined in the substrate 100 and/or the multi-layer. As an example, the display area DA and the non-display area NDA may be defined in the substrate 100. For example, the substrate 100 may include the display area DA and the non-display area NDA.

A plurality of sub-pixels P may be arranged in the display area DA. The plurality of sub-pixels P may be configured to display images. The sub-pixel P may be connected to the scan line SL and the data line DL. For example, the scan line SL extends in the first direction (e.g., the x direction), and the data line DL extends in the second direction (e.g., the y direction).

The non-display area NDA may be arranged outside the display area DA. The non-display area NDA may surround at least a portion of the display area DA. In an embodiment, the non-display area NDA may surround the display area DA entirely (or partially). A scan driver may be arranged in the non-display area NDA. For example, the scan driver may provide scan signals to each sub-pixel P. A data driver may be arranged in the non-display area NDA. For example, the data driver may provide data signals to the sub-pixel P. The non-display area NDA may include a pad area. In an embodiment, a pad may be arranged in the pad area. The pad may be exposed by not being covered by an insulating layer, and electrically connected to a printed circuit board or a driver integrated circuit (IC). Signals and/or voltages transferred from the printed circuit board or the driver IC through the pad may be transferred to the sub-pixel P arranged in the display area DA through a wiring connected to the pad.

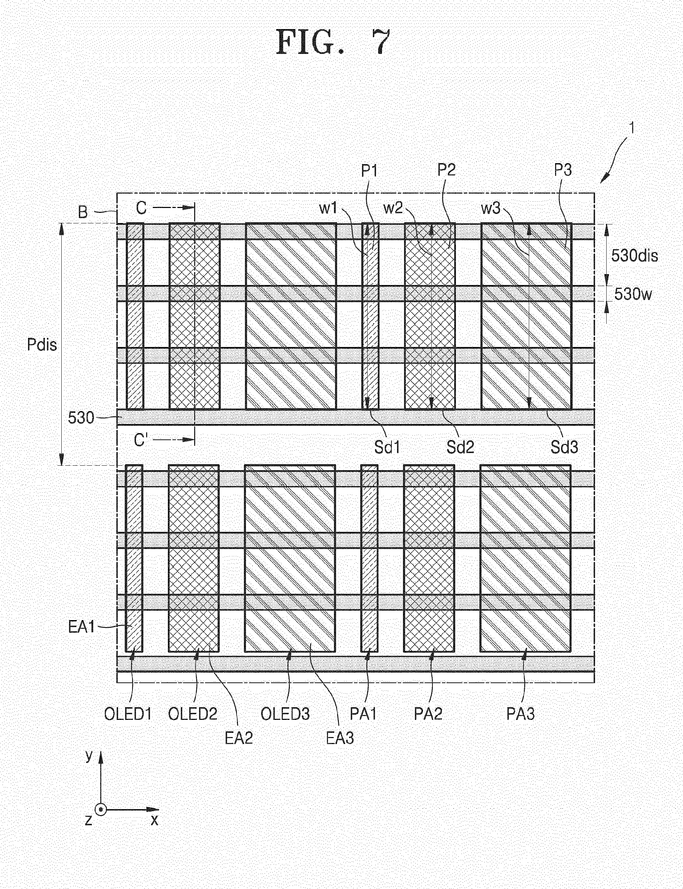

FIG. 7 is an enlarged view of a region B of the display apparatus 1 of FIG. 6 according to an embodiment.

Referring to FIG. 7, the display apparatus 1 may include a first sub-pixel P1, a second sub-pixel P2, a third sub-pixel P3, and the plurality of light-blocking lines 530. The first sub-pixel P1 may emit light in a first wavelength band. As an example, the first sub-pixel P1 may emit light having a wavelength in the range of about 630 nm to about 780 nm. For example, the first sub-pixel P1 may emit light in a red wavelength band. The first sub-pixel P1 may have a first side Sd1 extending in the first direction (e.g., the x direction). The first sub-pixel P1 may have a first width w1 in the second direction (e.g., the y direction) perpendicular to the first direction (e.g., the x direction). The first width w1 may be a maximum length of the first sub-pixel P1 in the second direction (e.g., the y direction) in a plan view. The first sub-pixel P1 may have a polygon shape (e.g., a parallelogram shape). In an embodiment, the first sub-pixel P1 may have a rectangular shape. The first sub-pixel P1 may be defined by a first emission area EA1 included in a first light-emitting element. As an example, the first emission area EA1 included in a first organic light-emitting diode OLED1 may define the first sub-pixel P1.

A second sub-pixel P2 may emit light in a second wavelength band. As an example, the second sub-pixel P2 may emit light having a wavelength in the range of about 495 nm to about 570 nm. For example, the second sub-pixel P2 may emit light in a green wavelength band. The second sub-pixel P2 may have a second side Sd2 extending in the first direction (e.g., the x direction). The second sub-pixel P2 may have a second width w2 extending in the second direction (e.g., the y direction). The second width w2 may be a maximum length of the second sub-pixel P2 in the second direction (e.g., the y direction) in a plan view. The second sub-pixel P2 may have a polygon shape (e.g., a parallelogram shape). In an embodiment, the second sub-pixel P2 may have a rectangular shape. The second sub-pixel P2 may be defined by a second emission area EA2 included in a second light-emitting element. As an example, the second emission area EA2 included in a second organic light-emitting diode OLED2 may define the second sub-pixel P2.

A third sub-pixel P3 may emit light in a third wavelength band. As an example, the third sub-pixel P3 may emit light having a wavelength in the range of about 450 nm to about 495 nm. For example, the third sub-pixel P3 may emit light in a blue wavelength band. The third sub-pixel P3 may have a third side Sd3 extending in the first direction (e.g., the x direction). The third sub-pixel P3 may have a third width w3 extending in the second direction (e.g., the y direction). The third width w3 may be a maximum length of the third sub-pixel P3 in the second direction (e.g., the y direction) in a plan view. The third sub-pixel P3 may have a polygon shape (e.g., a parallelogram shape). In an embodiment, the third sub-pixel P3 may have a rectangular shape. The third sub-pixel P3 may be defined by a third emission area EA3 included in a third light-emitting element. As an example, the third emission area EA3 included in a third organic light-emitting diode OLED3 may define the third sub-pixel P3.

An area PA2 of the second sub-pixel P2 may be about 2.8 times of an area PA1 of the first sub-pixel P1. An area PA3 of the third sub-pixel P3 may be about 5.4 times of the area PA1 of the first sub-pixel P1. A ratio of the area PA1 of the first sub-pixel P1, the area PA2 of the second sub-pixel P2, and the area PA3 of the third sub-pixel P3 may be about 1:2.8:5.4. For example, the display apparatus 1 may generate white light by using the first sub-pixel P1, the second sub-pixel P2, and the third sub-pixel P3.

The first sub-pixel P1, the second sub-pixel P2, and the third sub-pixel P3 may be arranged in the first direction (e.g., the x direction). The first sub-pixel P1, the second sub-pixel P2, and the third sub-pixel P3 may be sequentially arranged in the first direction (e.g., the x direction). The first sub-pixel P1, the second sub-pixel P2, and the third sub-pixel P3 may be repeatedly arranged in the first direction (e.g., the x direction). The first sub-pixel P1 may be provided in plurality, and the plurality of first sub-pixels P1 may be arranged in the second direction (e.g., the y direction). For example, the first sub-pixel P1 may include a plurality of first sub-pixels P1, and the plurality of first sub-pixels P1 may be arranged in the second direction (e.g., the y direction). The second sub-pixel P2 may be provided in plurality, and the plurality of second sub-pixels P2 may be arranged in the second direction (e.g., the y direction). For example, the second sub-pixel P2 may include a plurality of second sub-pixels P2, and the plurality of second sub-pixels P2 may be arranged in the second direction (e.g., the y direction). The third sub-pixel P3 may be provided in plurality, and the plurality of third sub-pixels P3 may be arranged in the second direction (e.g., the y direction). For example, the third sub-pixel P3 may include a plurality of third sub-pixels P3, and the plurality of third sub-pixels P3 may be arranged in the second direction (e.g., the y direction).

The plurality of light-blocking lines 530 may extend in the first direction (e.g., the x direction). In an embodiment, the plurality of light-blocking lines 530 may extend with an inclination of about 0.5° or less from the first direction (e.g., the x direction) in a plan view. In an embodiment, the plurality of light-blocking lines 530 may extend with an inclination of about 5° or less from the first direction (e.g., the x direction) in a plan view.

The plurality of light-blocking lines 530 may be spaced apart from each other with a first distance 530dis in the second direction (e.g., the y direction). The first distance 530dis may be a distance between the light-blocking lines adjacent to each other in the second direction (e.g., the y direction). As an example, the first distance 530dis may be a distance from the edge of a first light-blocking line to the edge of a second light-blocking line adjacent to the first light-blocking line. As another example, the first distance 530dis may be a distance from the center of the first light-blocking line to the center of the second light-blocking line adjacent to the first light-blocking line. The first distance 530dis may have the range of about 30 µm to about 60 µm. In an embodiment, the first distance 530dis may be about 39 µm. A width 530w of the light-blocking line 530 in the second direction (e.g., the y direction) may be about 10 µm.

Each of the first width w1, the second width w2, and the third width w3 may be an integer multiple of the first distance 530dis. In an embodiment, the first width w1, the second width w2, and the third width w3 may be substantially equal to each other. Each of the first width w1, the second width w2, and the third width w3 may be about three times of the first distance 530dis. As an example, each of the first width w1, the second width w2, and the third width w3 may be about 117 µm. In the specification, in case that each of the first width w1, the second width w2, and the third width w3 is an integer multiple of the first distance 530dis, it may in a range of deviation of about 1.5% from the integer multiple. As an example, each of the first width w1, the second width w2, and the third width w3 may be about 2.955 times to about 3.045 times of the first distance 530dis.

The plurality of light-blocking lines 530 may control light emitted from the first sub-pixel P1, the second sub-pixel P2, and the third sub-pixel P3 to transmit in various directions (e.g., a specific direction). As an example, a second direction (e.g., the y direction) component of light emitted from the first sub-pixel P1, the second sub-pixel P2, and the third sub-pixel P3 may be removed by the plurality of light-blocking lines 530. In the case where each of the first width w1, the second width w2, and the third width w3 is not an integer multiple of the first distance 530dis, moire may occur to the display apparatus 1. In an embodiment, each of the first width w1, the second width w2, and the third width w3 may be an integer multiple of the first distance 530dis, and occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the edge of one of the plurality of first sub-pixels P1 to the edge of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the edge of one of the plurality of second sub-pixels P2 to the edge of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the edge of one of the plurality of third sub-pixels P3 to the edge of another of the plurality of third sub-pixels P3 in the second direction (e.g., the y direction). For example, occurrence of moire may be prevented or reduced.

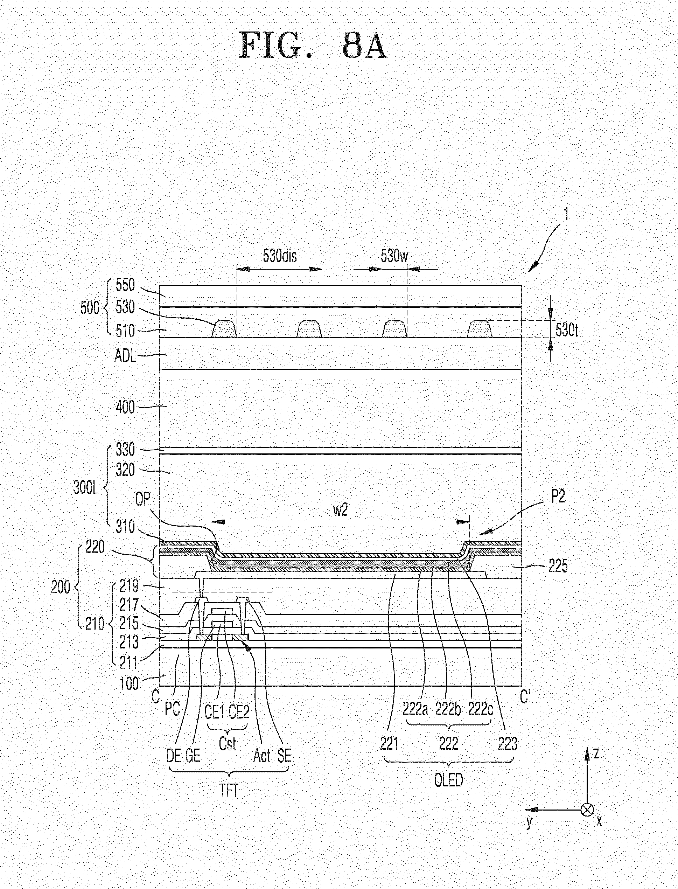

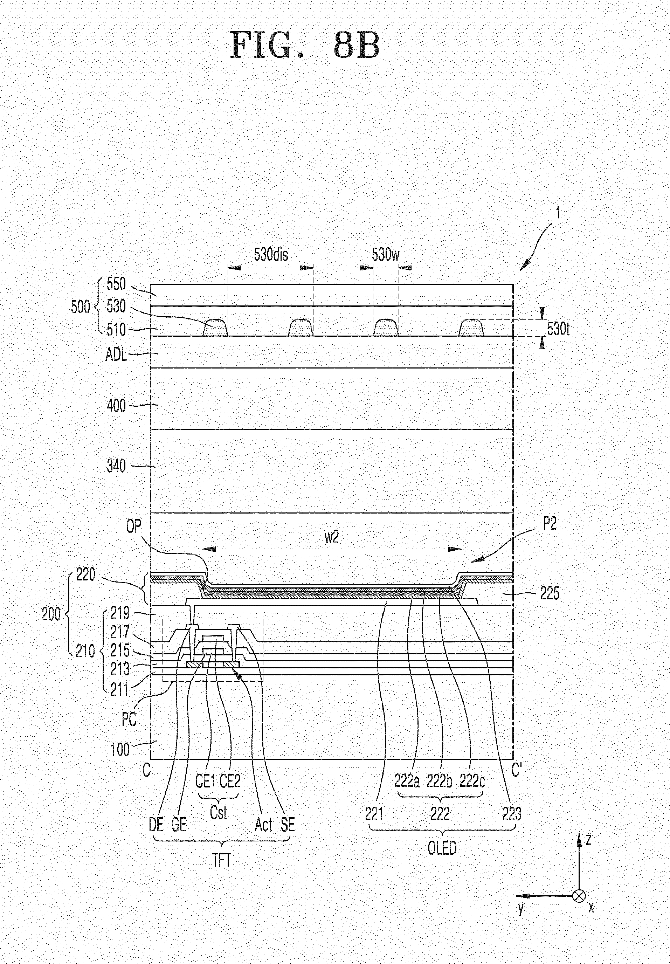

FIGS. 8A and 8B are schematic cross-sectional views of the display apparatus 1 of FIG. 7, taken along line C-C'. In FIGS. 8A and 8B, the same reference numerals as those of FIGS. 4A and 4B denote the same members, and thus, redundant descriptions thereof are omitted for descriptive convenience.

Referring to FIGS. 8A and 8B, the display apparatus 1 may include the substrate 100, the display layer 200, the encapsulation member, the anti-reflection layer 400, and the light path-controlling layer 500. The display layer 200 may be arranged on the substrate 100. The display layer 200 may include a pixel circuit layer 210 and a light-emitting element layer 220. The pixel circuit layer 210 may include a buffer layer 211, a first gate insulating layer 213, a second gate insulating layer 215, an interlayer insulating layer 217, an organic insulating layer 219, and a pixel circuit PC. The pixel circuit PC may include a thin-film transistor TFT and a storage capacitor Cst. The thin-film transistor TFT may include a semiconductor layer Act, a gate electrode GE, a source electrode SE, and a drain electrode DE.

The buffer layer 211 may be disposed on the substrate 100. The buffer layer 211 may include an inorganic insulating material such as silicon nitride (SiNₓ), silicon oxynitride (SiON), and silicon oxide (SiOx), and include a single layer or a multi-layer including the inorganic insulating materials.

The semiconductor layer Act may be arranged on the buffer layer 211. The semiconductor layer Act may include polycrystalline silicon. In another example, the semiconductor layer Act may include amorphous silicon, an oxide semiconductor, or an organic semiconductor. The semiconductor layer Act may include a channel region, a drain region, and a source region, the drain region and the source region being on two opposite sides of the channel region.

The first gate insulating layer 213 may be disposed on the semiconductor layer Act and the buffer layer 211. The first gate insulating layer 213 may include an inorganic insulating material such as silicon oxide (SiOx), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ). Zinc oxide (ZnOₓ) may be zinc oxide (ZnO) and/or zinc peroxide (ZnO₂).

The gate electrode GE may be disposed on the first gate insulating layer 213. The gate electrode GE may overlap the channel region. The gate electrode GE may include a low-resistance metal material. The gate electrode GE may include a conductive material including molybdenum (Mo), aluminum (Al), copper (Cu), and titanium (Ti) and have a single-layered structure or a multi-layered structure including the above materials.

The second gate insulating layer 215 may be disposed on the gate electrode GE and the first gate insulating layer 213. Similar to the first gate insulating layer 213, the second gate insulating layer 215 may include an inorganic insulating material including silicon oxide (SiOx), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ).

An upper electrode CE2 of the storage capacitor Cst may be arranged on the second gate insulating layer 215. The upper gate electrode CE2 may overlap (or face) the gate electrode GE therebelow. For example, the gate electrode GE and the upper gate electrode CE2 overlapping (or facing) each other with the second gate insulating layer 215 therebetween may form the storage capacitor Cst. For example, the gate electrode GE may serve as a lower electrode CE1 of the storage capacitor Cst. In an embodiment, the storage capacitor Cst may overlap (or face) the thin-film transistor TFT. In an embodiment, the storage capacitor Cst may not overlap (or face) the thin-film transistor TFT. The upper electrode CE2 may include aluminum (Al), platinum (Pt), palladium (Pd), silver (Ag), magnesium (Mg), gold (Au), nickel (Ni), neodymium (Nd), iridium (Ir), chrome (Cr), calcium (Ca), molybdenum (Mo), titanium (Ti), tungsten (W), and/or copper (Cu), and include a single layer or a multi-layer including the above materials.

The interlayer insulating layer 217 may be arranged on the upper electrode CE2 and the second gate insulating layer 215. The interlayer insulating layer 217 may include silicon oxide (SiOx), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ). The interlayer insulating layer 217 may include a single layer or a multi-layer including the inorganic insulating material.

The drain electrode DE and the source electrode SE may each be arranged on the interlayer insulating layer 217. The drain electrode DE and the source electrode SE may each be electrically connected to semiconductor layer Act. The drain electrode DE and the source electrode SE may each include a material having high conductivity. The drain electrode DE and the source electrode SE may each include a conductive material including molybdenum (Mo), aluminum (Al), copper (Cu), and titanium (Ti) and have a single-layered structure or a multi-layered structure including the above materials. In an embodiment, the drain electrode DE and the source electrode SE may each have a multi-layered structure of Ti/Al/Ti.

The organic insulating layer 219 may be disposed on the drain electrode DE, the source electrode SE, and the interlayer insulating layer 217. The organic insulating layer 219 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof. In an embodiment, the organic insulating layer 219 may include a first organic insulating layer and a second organic insulating layer.

The light-emitting element layer 220 may be disposed on the pixel circuit layer 210. The light-emitting element layer 220 may be disposed on the organic insulating layer 219. The light-emitting element layer 220 may include a light-emitting element implementing a sub-pixel. The light-emitting element may be an organic light-emitting diode OLED. The light-emitting element layer 220 may include a first organic light-emitting diode, a second organic light-emitting diode, and a third organic light-emitting diode. In FIGS. 8A and 8B, the organic light-emitting diode OLED may implement the second sub-pixel P2.

The organic light-emitting diode OLED may include a pixel electrode 221, an intermediate layer 222, and an opposite electrode 223. The pixel electrode 221 may be electrically connected to the thin-film transistor TFT through a contact hole of the organic insulating layer 219. The pixel electrode 221 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In another example, the pixel electrode 221 may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. In another example, the pixel electrode 221 may further include a layer on/under the reflective layer, the layer including ITO, IZO, ZnO, or In₂O₃. As an example, the pixel electrode 221 may have a multi-layered structure of ITO/Ag/ITO.

A pixel-defining layer 225 may cover the edge of the pixel electrode 221. The pixel-defining layer 225 may include an opening OP. The opening OP may expose the central portion of the pixel electrode 221. The opening OP may define an emission area of light emitted from the organic light-emitting diode OLED. In an embodiment, the second width w2 may be defined by the size of the opening OP in the second direction (e.g., the y direction). The second width w2 may be about 117 µm. In an embodiment, the pixel-defining layer 225 may include an organic material and/or an inorganic material. In an embodiment, the pixel-defining layer 225 may be transparent. In an embodiment, the pixel-defining layer 225 may include a black matrix. For example, the pixel-defining layer 225 may be opaque.

The intermediate layer 222 may include a first functional layer 222a, an emission layer 222b, and a second functional layer 222c. The emission layer 222b may include a polymer organic material or a low-molecular weight organic material emitting light having a color (e.g., a preset color). In an embodiment, at least one of the first functional layer 222a and the second functional layer 222c may be a common layer arranged in the display area entirely (or partially). The first functional layer 222a may include, for example, a hole transport layer (HTL), or include an HTL and a hole injection layer (HIL). The second functional layer 222c may include an electron transport layer (ETL) and/or an electron injection layer (EIL). In an embodiment, the second functional layer 222c may be omitted.

The opposite electrode 223 may be disposed on the emission layer 222b. The opposite electrode 223 may include a conductive material having a low work function. As an example, the opposite electrode 223 may include a transparent layer (or a semi-transparent layer) including silver (Ag), magnesium (Mg), aluminum (Al), platinum (Pt), palladium (Pd), gold (Au), nickel (Ni), neodymium (Nd), iridium (Ir), chrome (Cr), or an alloy thereof. In another example, the opposite electrode 223 may further include a layer on the (semi) transparent layer, the layer including ITO, IZO, ZnO, or In₂O₃.

In an embodiment, a capping layer may be further arranged on the opposite electrode 223. The capping layer may include lithium fluoride (LiF), an inorganic material, and/or an organic material.

The encapsulation member may be disposed on the display layer 200. Referring to FIG. 8A, the encapsulation member may include an encapsulation layer 300L. The encapsulation layer 300L may include at least one inorganic encapsulation layer and at least one organic encapsulation layer. It is shown in FIG. 8A that the encapsulation layer 300L includes a first inorganic encapsulation layer 310, an organic encapsulation layer 320, and a second inorganic encapsulation layer 330. For example, a thickness from the substrate 100 to the encapsulation layer 300L in a third direction (e.g., a z direction) may be about 30 µm. Referring to FIG. 8B, the encapsulation member may include the encapsulation substrate 340. In an embodiment, the thickness of the encapsulation substrate 340 in the third direction (e.g., the z direction) may be about 450 µm. In the case where the substrate 100 includes glass, the thickness of the substrate 100 may be about 450 µm.

Referring to FIGS. 8A and 8B, the anti-reflection layer 400 may be disposed on the encapsulation member. The thickness of the anti-reflection layer 400 in the third direction (e.g., the z direction) may be about 250 µm.

The light path-controlling layer 500 may be disposed on the anti-reflection layer 400. An adhesive layer ADL may be disposed between the light path-controlling layer 500 and the anti-reflection layer 400. The adhesive layer ADL may be a transparent adhesive member such as an optically clear adhesive (OCA) film. In an embodiment, the thickness of the adhesive layer ADL in the third direction (e.g., the z direction) may be about 100 µm.

The light path-controlling layer 500 may include the first layer 510, the plurality of light-blocking lines 530, and the second layer 550. The first layer 510 may include a transparent resin. In an embodiment, the first layer 510 may include a plurality of grooves. The plurality of grooves may be arranged with a constant distance. The plurality of light-blocking lines 530 may fill the plurality of grooves, respectively. The plurality of light-blocking lines 530 may be spaced apart from each other with a first distance (or a constant distance) 530dis in the second direction (e.g., the y direction). The first distance 530dis may be a distance between the light-blocking lines adjacent to each other in the second direction (e.g., the y direction). As an example, the first distance 530dis may be a distance from the edge of a first light-blocking line to the edge of a second light-blocking line adjacent to the first light-blocking line. The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm. A thickness 530t of the light-blocking line 530 in the third direction (e.g., the z direction) may be in the range of about 80 µm to about 120 µm. As an example, the thickness 530t of the light-blocking line 530 in the third direction (e.g., the z direction) may be about 100 µm. The plurality of light-blocking lines 530 may each include a light-blocking material.

The second width w2 may be an integer multiple of the first distance 530dis. In an embodiment, the second width w2 may be about three times of the first distance 530dis. As an example, the second width w2 may be about 117 µm. For example, occurrence of moire may be prevented or reduced. Accordingly, the quality of the display apparatus 1 may be improved.

The second layer 550 may be disposed on the first layer 510 and the plurality of light-blocking lines 530. The second layer 550 may include a polymer resin. As an example, the second layer 550 may include polycarbonate. In an embodiment, the thickness of the second layer 550 in the third direction (e.g., the z direction) may be about 100 µm.

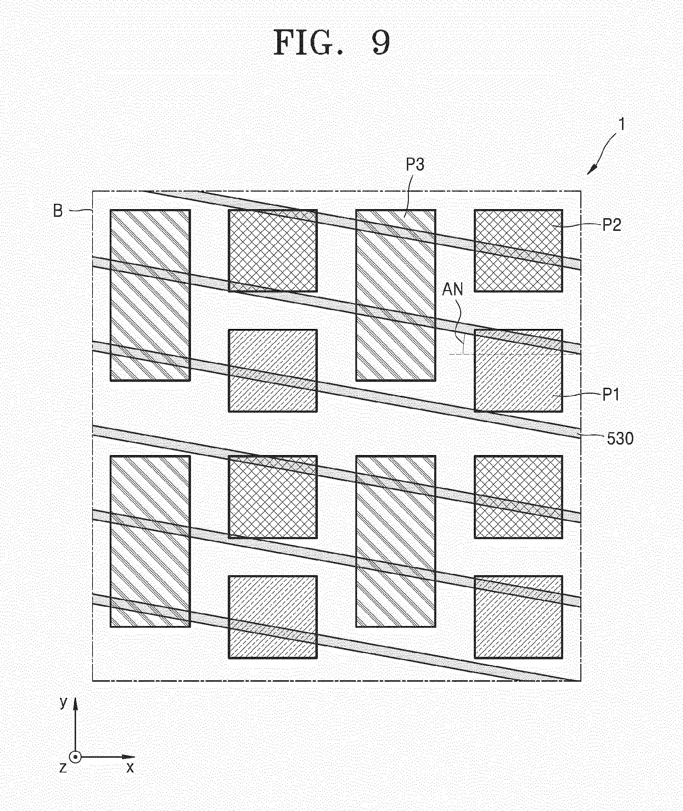

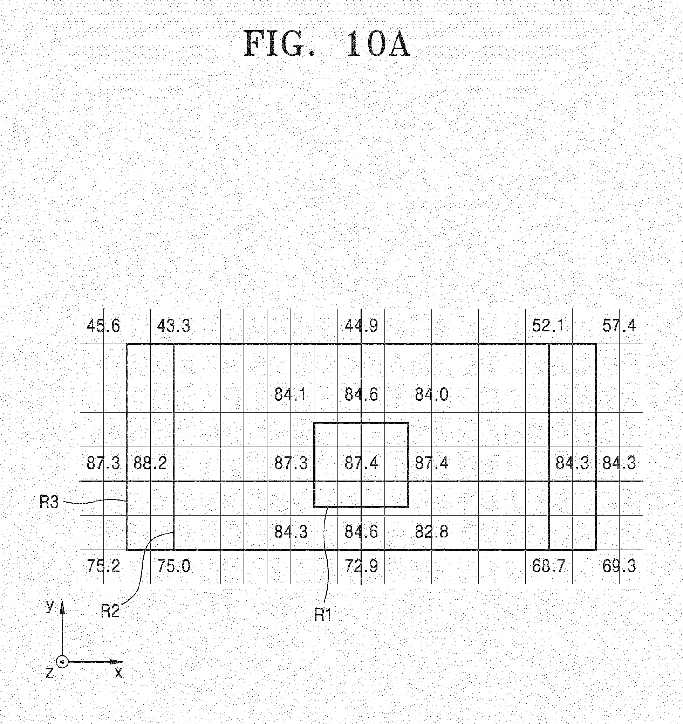

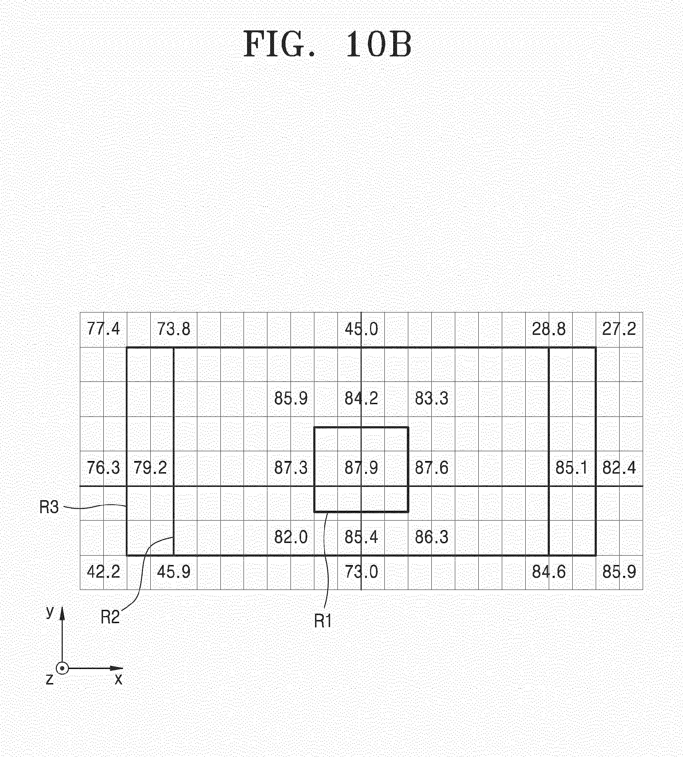

FIG. 9 is an enlarged view of a region B of the display apparatus 1 of FIG. 6 according to a comparative example. FIG. 10A is a view showing brightness simulation results of the display apparatus 1 of FIG. 7. FIG. 10B is a view showing brightness simulation results of the display apparatus 1 of FIG. 9.

Referring to FIG. 9, the display apparatus 1 according to a comparative example may include a first sub-pixel P1, a second sub-pixel P2, a third sub-pixel P3, and the plurality of light-blocking lines 530. In a comparative example, the plurality of light-blocking lines 530 may extend with an inclination in a plan view. For example, the plurality of light-blocking lines 530 may extend with an inclination from the first direction (e.g., the x direction). The extension direction of the plurality of light-blocking lines 530 and the first direction (e.g., the x direction) may form an angle (e.g., a preset angle) AN. The angle AN may be about 9°.

Referring to FIGS. 10A and 10B, the simulation results may include a first region R1, a second region R2, and a third region R3. The first region R1 may be a region located within 10° left and right, 8° in the upper portion, and 4° in the lower portion. The second region R2 may be a region located within 40° left and right, 20° in the upper portion, and 10° in the lower portion. The third region R3 may be a region located within 50° left and right, 20° in the upper portion, and 10° in the lower portion.

Referring to FIG. 10A, a minimum brightness of the second region R2 may be about 43.3% of a front brightness in the display apparatus 1 according to an embodiment described with reference to FIG. 7. Referring to FIG. 10B, a minimum brightness of the second region R2 may be about 28.8% of a front brightness in the display apparatus 1 according to an embodiment described with reference to FIG. 9. Though moire phenomenon may be reduced even in the display apparatus 1 according to a comparative example described with reference to FIG. 9, a deviation of brightness may increase for each position. In the display apparatus 1 according to an embodiment described with reference to FIG. 7, the deviation in brightness may be reduced compared to the display apparatus 1 according to a comparative example described with reference to FIG. 9, and the moire phenomenon may be prevented or reduced.

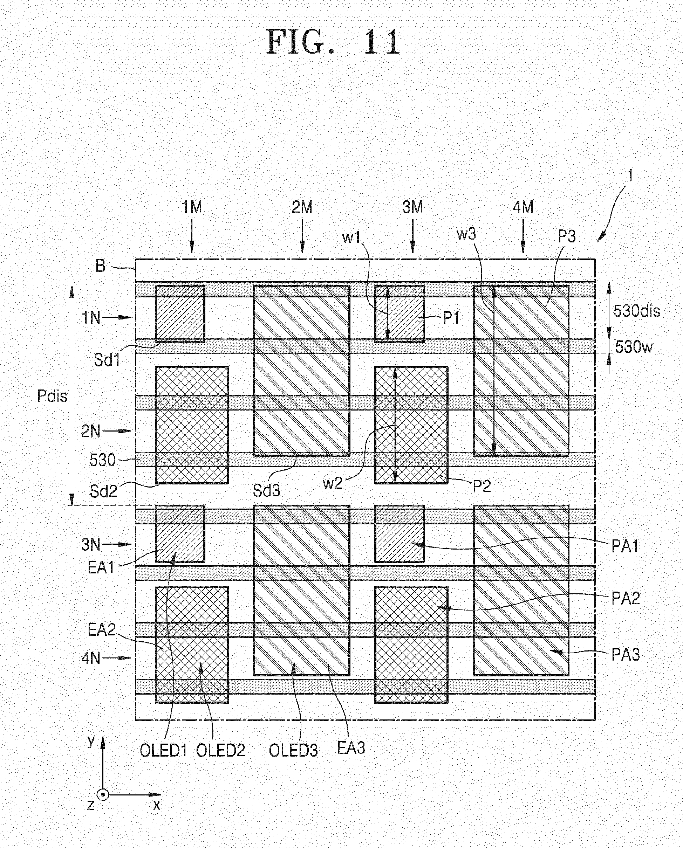

FIG. 11 is an enlarged view of a region B of the display apparatus 1 of FIG. 6 according to an embodiment. In FIG. 11, the same reference numerals as those of FIG. 7 denote the same members, and thus, redundant descriptions thereof are omitted for descriptive convenience.

Referring to FIG. 11, the display apparatus 1 may include a first sub-pixel P1, a second sub-pixel P2, a third sub-pixel P3, and the plurality of light-blocking lines 530. The first sub-pixel P1 may have a first side Sd1 extending in the first direction (e.g., the x direction). The first sub-pixel P1 may have a first width w1 in the second direction (e.g., the y direction) perpendicular to the first direction (e.g., the x direction). The first sub-pixel P1 may have a polygon shape (e.g., a parallelogram shape). In an embodiment, the first sub-pixel P1 may have a rectangular shape. The first sub-pixel P1 may include a plurality of first sub-pixels P1.

The second sub-pixel P2 may have a second side Sd2 extending in the first direction (e.g., the x direction). The second sub-pixel P2 may have a second width w2 extending in the second direction (e.g., the y direction). The second sub-pixel P2 may have a polygon shape (e.g., a parallelogram shape). In an embodiment, the second sub-pixel P2 may have a rectangular shape. The second sub-pixel P2 may include a plurality of second sub-pixels P2.

The third sub-pixel P3 may have a third side Sd3 extending in the first direction (e.g., the x direction). The third sub-pixel P3 may have a third width w3 extending in the second direction (e.g., the y direction). The third sub-pixel P3 may have a polygon shape (e.g., a parallelogram shape). In an embodiment, the third sub-pixel P3 may have a rectangular shape. The third sub-pixel P3 may include a plurality of third sub-pixels P3.

An area PA2 of the second sub-pixel P2 may be about 2.8 times of an area PA1 of the first sub-pixel P1. An area PA3 of the third sub-pixel P3 may be about 5.4 times of the area PA1 of the first sub-pixel P1. A ratio of the area PA1 of the first sub-pixel P1, the area PA2 of the second sub-pixel P2, and the area PA3 of the third sub-pixel P3 may be about 1:2.8:5.4. For example, the display apparatus 1 may generate white light by using the first sub-pixel P1, the second sub-pixel P2, and the third sub-pixel P3.

The first sub-pixel P1 and the second sub-pixel P2 may be arranged in turns (or alternately) on a first column 1M. For example, the first sub-pixel P1 and the second sub-pixel P2 may be arranged in turns (or alternately) in the second direction (e.g., the y direction). A plurality of third sub-pixels P3 may be arranged on a second column 2M adjacent to the first column 1M. For example, the plurality of third sub-pixels P3 may be arranged in the second direction (e.g., the y direction). The first sub-pixel P1 and the second sub-pixel P2 may be arranged in turns (or alternately) on a third column 3M adjacent to the second column 2M. The plurality of third sub-pixels P3 may be arranged in the second direction (e.g., the y direction) on a fourth column 4M adjacent to the third column 3M. Such configuration may be repeated.

The plurality of first sub-pixels P1 may be spaced apart from each other on a first row 1N. For example, the plurality of first sub-pixels P1 may be spaced apart from each other in the first direction (e.g., the x direction). The third sub-pixel P3 may be arranged between the plurality of first sub-pixels P1 on the first row 1N. The plurality of second sub-pixels P2 may be spaced apart from each other in the first direction (e.g., the x direction) on a second row 2N adjacent to the first row 1N. For example, the plurality of second sub-pixels P2 may be spaced apart from each other in the first direction (e.g., the x direction). The third sub-pixel P3 may be arranged between the plurality of second sub-pixels P2 on the second row 2N. The plurality of first sub-pixels P1 may be spaced apart from each other on a third row 3N adjacent to the second row 2N. The third sub-pixel P3 may be arranged between the plurality of first sub-pixels P1 on the third row 3N. The plurality of second sub-pixels P2 may be spaced apart from each other in the first direction (e.g., the x direction) on a fourth row 4N adjacent to the third row 3N. The third sub-pixel P3 may be arranged between the plurality of second sub-pixels P2 on the fourth row 4N. Such configuration may be repeated.

The plurality of light-blocking lines 530 may extend in the first direction (e.g., the x direction). The plurality of light-blocking lines 530 may be spaced apart from each other with a first distance 530dis in the second direction (e.g., the y direction). The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm.

Each of the first width w1, the second width w2, and the third width w3 may be an integer multiple of the first distance 530dis. In an embodiment, the first width w1 may be substantially the same as the first distance 530dis. As an example, the first width w1 may be about 39 µm. The second width w2 may be about two times of the first distance 530dis. As an example, the second width w2 may be about 78 µm. The third width w3 may be about three times of the first distance 530dis. As an example, the third width w3 may be about 117 µm. In an embodiment, each of the first width w1, the second width w2, and the third width w3 may be an integer multiple of the first distance 530dis, and occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the edge of one of the plurality of first sub-pixels P1 to the edge of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the edge of one of the plurality of second sub-pixels P2 to the edge of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the edge of one of the plurality of third sub-pixels P3 to the edge of another of the plurality of third sub-pixels P3 in the second direction (e.g., the y direction). For example, occurrence of moire may be prevented or reduced.

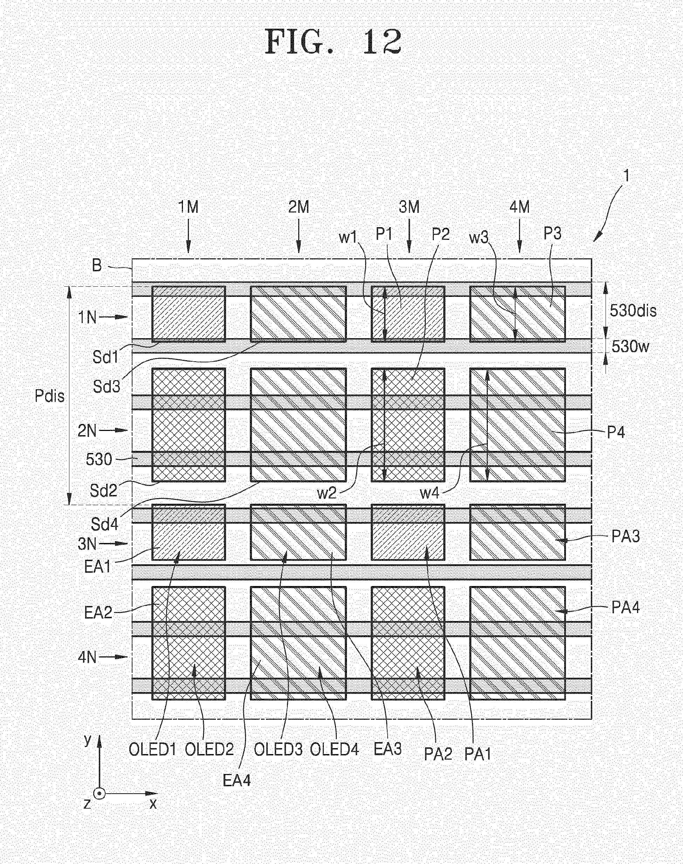

FIG. 12 is an enlarged view of the region B of the display apparatus 1 of FIG. 6 according to another example. In FIG. 12, the same reference numerals as those of FIG. 7 denote the same members, and thus, redundant descriptions thereof are omitted for descriptive convenience.

Referring to FIG. 12, the display apparatus 1 may include a first sub-pixel P1 having an area PA1, a second sub-pixel P2 having an area PA2, a third sub-pixel P3 having an area PA3, the fourth sub-pixel P4 having an area PA4, and the plurality of light-blocking lines 530. The first sub-pixel P1 may have a first side Sd1 extending in the first direction (e.g., the x direction). The first sub-pixel P1 may have a first width w1 in the second direction (e.g., the y direction) perpendicular to the first direction (e.g., the x direction). The first sub-pixel P1 may have a polygon shape (e.g., a parallelogram shape). In an embodiment, the first sub-pixel P1 may have a rectangular shape. The first sub-pixel P1 may include a plurality of first sub-pixels P1.

The second sub-pixel P2 may have a second side Sd2 extending in the first direction (e.g., the x direction). The second sub-pixel P2 may have a second width w2 extending in the second direction (e.g., the y direction). The second sub-pixel P2 may have a polygon shape (e.g., a parallelogram shape). In an embodiment, the second sub-pixel P2 may have a rectangular shape. The second sub-pixel P2 may include a plurality of second sub-pixels P2.

The third sub-pixel P3 may have a third side Sd3 extending in the first direction (e.g., the x direction). The third sub-pixel P3 may have a third width w3 extending in the second direction (e.g., the y direction). The third sub-pixel P3 may have a polygon shape (e.g., a parallelogram shape). In an embodiment, the third sub-pixel P3 may have a rectangular shape. The third sub-pixel P3 may include a plurality of third sub-pixels P3.

The fourth sub-pixel P4 may emit light in the same wavelength band as that of the third sub-pixel P3. The fourth sub-pixel P4 may emit light in a third wavelength band. As an example, the fourth sub-pixel P4 may emit light having a wavelength band in the range of about 450 nm to about 495 nm. For example, the fourth sub-pixel P4 may emit light in a blue wavelength band. The fourth sub-pixel P4 may have a fourth side Sd4 extending in the first direction (e.g., the x direction). The fourth sub-pixel P4 may have a fourth width w4 extending in the second direction (e.g., the y direction). The fourth width w4 may be a maximum length of the fourth sub-pixel P4 in the second direction (e.g., the y direction) in a plan view. The fourth sub-pixel P4 may have a polygon shape (e.g., a parallelogram shape). In an embodiment, the fourth sub-pixel P4 may have a rectangular shape. The fourth sub-pixel P4 may be defined by a fourth emission area EA4 included in a fourth light-emitting element. As an example, the fourth emission area EA4 included in a fourth organic light-emitting diode OLED4 may define the fourth sub-pixel P4. The fourth sub-pixel P4 may include a plurality of fourth sub-pixels P4.

The first sub-pixel P1 and the second sub-pixel P2 may be arranged in turns (or alternately) on a first column 1M. For example, the first sub-pixel P1 and the second sub-pixel P2 may be arranged in turns (or alternately) in the second direction (e.g., the y direction). The third sub-pixel P3 and the fourth sub-pixel P4 may be arranged in turns (or alternately) on the second column 2M adjacent to the first column 1M. For example, the third sub-pixel P3 and the fourth sub-pixel P4 may be arranged in turns (or alternately) in the second direction (e.g., the y direction). The first sub-pixel P1 and the second sub-pixel P2 may be arranged in turns (or alternately) on a third column 3M adjacent to the second column 2M. The third sub-pixel P3 and the fourth sub-pixel P4 may be arranged in turns (or alternately) on the fourth column 4M adjacent to the third column 3M. Such configuration may be repeated.

The first sub-pixel P1 and the third sub-pixel P3 may be arranged in turns (or alternately) on the first row 1N. For example, the first sub-pixel P1 and the third sub-pixel P3 may be arranged in the first direction (e.g., the x direction). The second sub-pixel P2 and the fourth sub-pixel P4 may be arranged in turns (or alternately) on the second row 2N adjacent to the first row 1N. For example, the second sub-pixel P2 and the fourth sub-pixel P4 may be arranged in the first direction (e.g., the x direction). The first sub-pixel P1 and the third sub-pixel P3 may be arranged in turns (or alternately) on the third row 3N adjacent to the second row 2N. The second sub-pixel P2 and the fourth sub-pixel P4 may be arranged in turns (or alternately) on the fourth row 4N adjacent to the third row 3N.

The plurality of light-blocking lines 530 may extend in the first direction (e.g., the x direction). The plurality of light-blocking lines 530 may be spaced apart from each other with a first distance 530dis in the second direction (e.g., the y direction). The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm.

Each of the first width w1, the second width w2, the third width w3, and the fourth width w4 may be an integer multiple of the first distance 530dis. In an embodiment, the first width w1 may be substantially the same as the first distance 530dis. As an example, the first width w1 may be about 39 µm. The second width w2 may be about two times of the first distance 530dis. As an example, the second width w2 may be about 78 µm. The third width w3 may be substantially the same as the first distance 530dis. As an example, the third width w3 may be about 39 µm. The fourth width w4 may be about two times of the first distance 530dis. As an example, the fourth width w4 may be about 78 µm. In an embodiment, each of the first width w1, the second width w2, and the third width w3 may be an integer multiple of the first distance 530dis, and occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the edge of one of the plurality of first sub-pixels P1 to the edge of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the edge of one of the plurality of second sub-pixels P2 to the edge of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the edge of one of the plurality of third sub-pixels P3 to the edge of another of the plurality of third sub-pixels P3 in the second direction (e.g., the y direction). The plurality of fourth sub-pixels P4 may be spaced apart from each other, and a distance with which the plurality of fourth sub-pixels P4 are spaced apart from each other in the second direction (e.g., the y direction) may not be an integer multiple of the first distance 530dis. The distance with which the plurality of fourth sub-pixels P4 are spaced apart from each other in the second direction (e.g., the y direction) may be a distance from the edge of one of the plurality of fourth sub-pixels P4 to the edge of another of the plurality of fourth sub-pixels P4 in the second direction (e.g., the y direction). For example, occurrence of moire may be prevented or reduced.

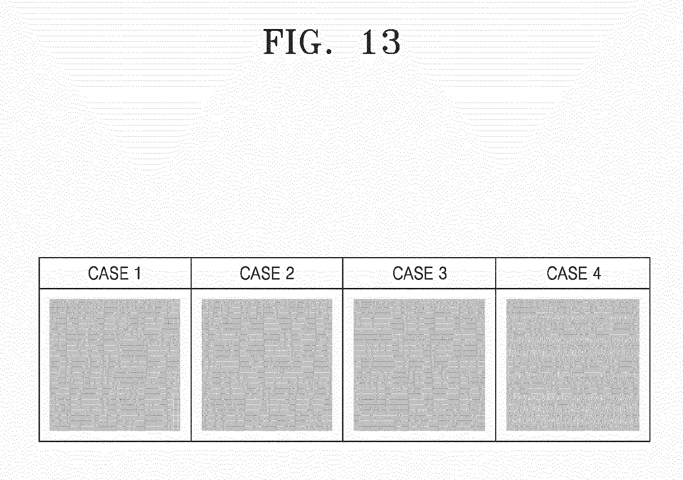

FIG. 13 is a table showing simulation results according to embodiments and simulation results according to a comparative example.

Referring to FIG. 13, CASE 1 is a simulation result of the embodiment described with reference to FIG. 7. CASE 2 is a simulation result of the embodiment described with reference to FIG. 11. CASE 3 is a simulation result of the embodiment described with reference to FIG. 12. CASE 4 is a simulation result of a comparative example in which each of the first width, the second width, and the third width is not an integer multiple of a first distance in the embodiment described with reference to FIG. 7. In CASE 4, each of the first width, the second width, and the third width is about 115 µm, and the first distance is about 39 µm. About 115 µm is a numerical value deviating from an integer multiple of about 39 µm by about 1.5% or more.

In CASE 1, it may be determined that moire does not occur. In CASE 1, brightness uniformity is 99.74, and just noticeable difference (JND) is 0.38.

In CASE 2, it may be determined that moire does not occur. In CASE 2, brightness uniformity is 99.80, and just noticeable difference (JND) is 0.29.

In CASE 3, it may be determined that moire does not occur. In CASE 3, brightness uniformity is 99.79, and just noticeable difference (JND) is 0.30.

In CASE 4, it may be determined that moire does not occur. In CASE 4, brightness uniformity is 98.95, and just noticeable difference (JND) is 1.57. Accordingly, as in an embodiment, in the case where each of the first width, the second width, and the third width is an integer multiple of the first distance, occurrence of moire may be prevented or reduced.

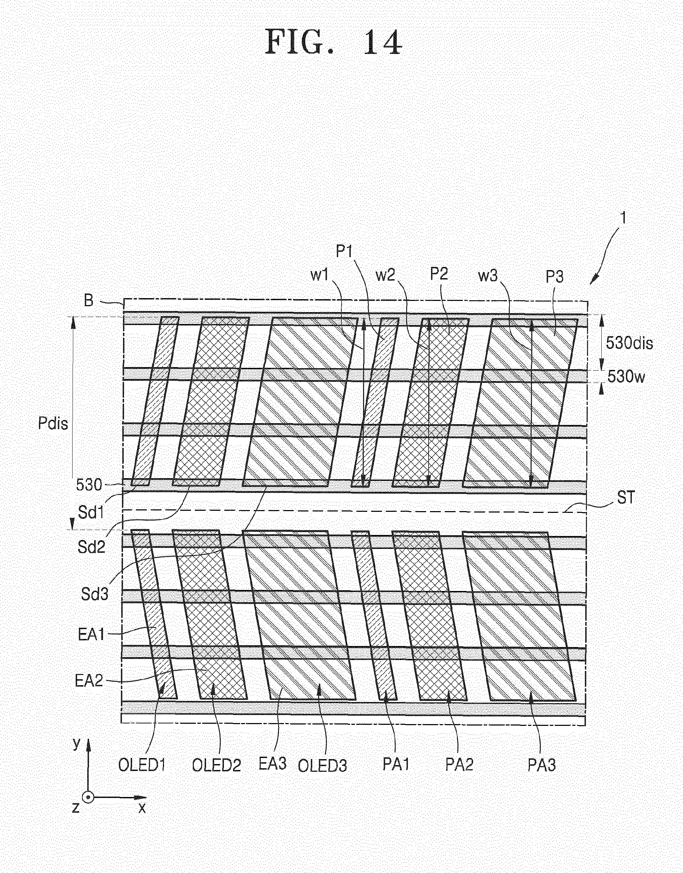

FIG. 14 is an enlarged view of the region B of the display apparatus 1 of FIG. 6 according to another example. In FIG. 14, the same reference numerals as those of FIG. 7 denote the same members, and thus, redundant descriptions thereof are omitted for descriptive convenience.

Referring to FIG. 14, the display apparatus 1 may include a first sub-pixel P1, a second sub-pixel P2, a third sub-pixel P3, and the plurality of light-blocking lines 530. The first sub-pixel P1 may have a first side Sd1 extending in the first direction (e.g., the x direction). The first sub-pixel P1 may have a first width w1 in the second direction (e.g., the y direction) perpendicular to the first direction (e.g., the x direction). The first width w1 may be a maximum length of the first sub-pixel P1 in the second direction (e.g., the y direction) in a plan view. The first sub-pixel P1 may have a parallelogram shape. The first sub-pixel P1 may include a plurality of first sub-pixels P1.

The second sub-pixel P2 may have a second side Sd2 extending in the first direction (e.g., the x direction). The second sub-pixel P2 may have a second width w2 extending in the second direction (e.g., the y direction). The second width w2 may be a maximum length of the second sub-pixel P2 in the second direction (e.g., the y direction) in a plan view. The second sub-pixel P2 may have a polygon shape (e.g., a parallelogram shape). The second sub-pixel P2 may include a plurality of second sub-pixels P2.

The third sub-pixel P3 may have a third side Sd3 extending in the first direction (e.g., the x direction). The third sub-pixel P3 may have a third width w3 extending in the second direction (e.g., the y direction). The third width w3 may be a maximum length of the third sub-pixel P3 in the second direction (e.g., the y direction) in a plan view. The third sub-pixel P3 may have a polygon shape (e.g., a parallelogram shape). The third sub-pixel P3 may include a plurality of third sub-pixels P3.

An area PA2 of the second sub-pixel P2 may be about 2.8 times of an area PA1 of the first sub-pixel P1. An area PA3 of the third sub-pixel P3 may be about 5.4 times of the area PA1 of the first sub-pixel P1. A ratio of the area PA1 of the first sub-pixel P1, the area PA2 of the second sub-pixel P2, and the area PA3 of the third sub-pixel P3 may be about 1:2.8:5.4. For example, the display apparatus 1 may generate white light by using the first sub-pixel P1, the second sub-pixel P2, and the third sub-pixel P3.

The first sub-pixel P1, the second sub-pixel P2, and the third sub-pixel P3 may be arranged in the first direction (e.g., the x direction). The first sub-pixel P1, the second sub-pixel P2, and the third sub-pixel P3 may be sequentially arranged in the first direction (e.g., the x direction). The first sub-pixel P1, the second sub-pixel P2, and the third sub-pixel P3 may be repeatedly arranged in the first direction (e.g., the x direction).

Each of the first sub-pixel P1, the second sub-pixel P2, and the third sub-pixel P3 may be provided in plurality. The shape of the plurality of first sub-pixels P1 may be symmetric with respect to a virtual straight line ST extending in the first direction (e.g., the x direction). The shape of the plurality of second sub-pixels P2 may be symmetric with respect to a virtual straight line ST extending in the first direction (e.g., the x direction).

The plurality of light-blocking lines 530 may extend in the first direction (e.g., the x direction). The plurality of light-blocking lines 530 may be spaced apart from each other with a first distance 530dis in the second direction (e.g., the y direction). The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm.

Each of the first width w1, the second width w2, and the third width w3 may be an integer multiple of the first distance 530dis. In an embodiment, the first width w1, the second width w2, and the third width w3 may be substantially equal to each other. Each of the first width w1, the second width w2, and the third width w3 may be about three times of the first distance 530dis. As an example, each of the first width w1, the second width w2, and the third width w3 may be about 117 µm. In an embodiment, each of the first width w1, the second width w2, and the third width w3 may be an integer multiple of the first distance 530dis, and occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the edge of one of the plurality of first sub-pixels P1 to the edge of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the edge of one of the plurality of second sub-pixels P2 to the edge of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the edge of one of the plurality of third sub-pixels P3 to the edge of another of the plurality of third sub-pixels P3 in the second direction (e.g., the y direction). For example, occurrence of moire may be prevented or reduced.

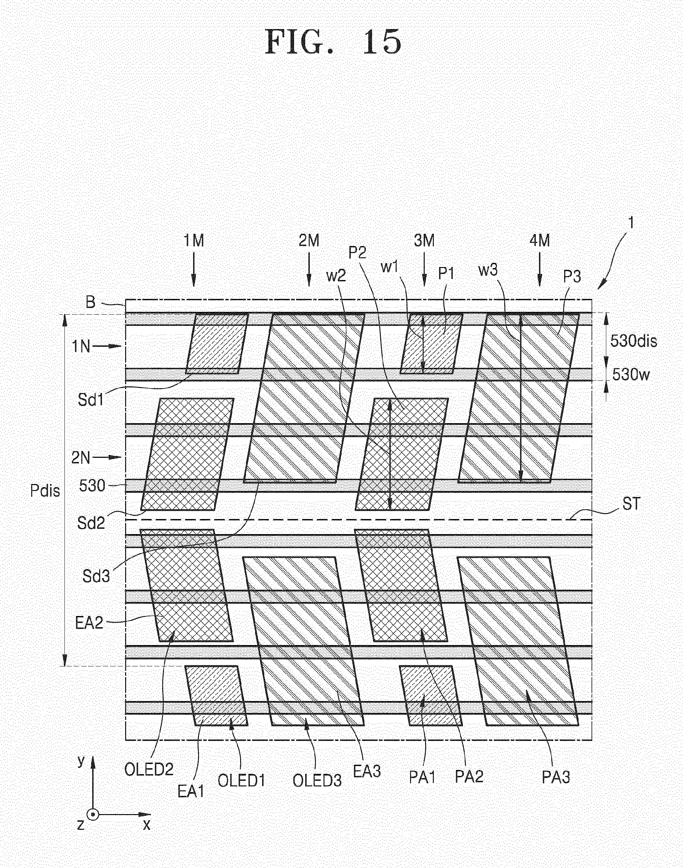

FIG. 15 is an enlarged view of the region B of the display apparatus 1 of FIG. 6 according to another example. In FIG. 15, the same reference numerals as those of FIG. 7 denote the same members, and thus, redundant descriptions thereof are omitted for descriptive convenience.

Referring to FIG. 15, the display apparatus 1 may include a first sub-pixel P1, a second sub-pixel P2, a third sub-pixel P3, and the plurality of light-blocking lines 530. The first sub-pixel P1 may have a first side Sd1 extending in the first direction (e.g., the x direction). The first sub-pixel P1 may have a first width w1 in the second direction (e.g., the y direction) perpendicular to the first direction (e.g., the x direction). The first sub-pixel P1 may have a polygon shape (e.g., a parallelogram shape). The first sub-pixel P1 may include a plurality of first sub-pixels P1.

The second sub-pixel P2 may have a second side Sd2 extending in the first direction (e.g., the x direction). The second sub-pixel P2 may have a second width w2 extending in the second direction (e.g., the y direction). The second sub-pixel P2 may have a polygon shape (e.g., a parallelogram shape). The second sub-pixel P2 may include a plurality of second sub-pixels P2.

The third sub-pixel P3 may have a third side Sd3 extending in the first direction (e.g., the x direction). The third sub-pixel P3 may have a third width w3 extending in the second direction (e.g., the y direction). The third sub-pixel P3 may have a polygon shape (e.g., a parallelogram shape). The third sub-pixel P3 may include a plurality of third sub-pixels P3.

An area PA2 of the second sub-pixel P2 may be about 2.8 times of an area PA1 of the first sub-pixel P1. An area PA3 of the third sub-pixel P3 may be about 5.4 times of an area PA1 of the first sub-pixel P1. A ratio of the area PA1 of the first sub-pixel P1, the area PA2 of the second sub-pixel P2, and the area PA3 of the third sub-pixel P3 may be about 1:2.8:5.4. For example, the display apparatus 1 may generate white light by using the first sub-pixel P1, the second sub-pixel P2, and the third sub-pixel P3.

The first sub-pixel P1 and the second sub-pixel P2 may be arranged on a first column 1M. Each of the first sub-pixel P1 and the second sub-pixel P2 may be provided in plurality. The shape and the position of the plurality of first sub-pixels P1 on the first column 1M may be symmetric with respect to a virtual straight line ST extending in the first direction (e.g., the x direction). The shape and the position of the plurality of second sub-pixels P2 on the first column 1M may be symmetric with respect to a virtual straight line ST extending in the first direction (e.g., the x direction).

The third sub-pixel P3 may be arranged on a second column 2M adjacent to the first column 1M. The third sub-pixel P3 may be provided in plurality on the second column 2M. The shape and the position of the plurality of third sub-pixels P3 on the second column 2M may be symmetric with respect to a virtual straight line ST.

The first sub-pixel P1 and the second sub-pixel P2 may be arranged on a third column 3M adjacent to the second column 2M. Each of the first sub-pixel P1 and the second sub-pixel P2 may be provided in plurality on the third column 3M. The shape and the position of the plurality of first sub-pixels P1 on the third column 3M may be symmetric with respect to a virtual straight line ST. The shape and the position of the plurality of second sub-pixels P2 on the third column 3M may be symmetric with respect to a virtual straight line ST.

The third sub-pixel P3 may be arranged on a fourth column 4M adjacent to the third column 3M. The third sub-pixel P3 may be provided in plurality on the fourth column 4M. The shape and the position of the plurality of third sub-pixels P3 on the fourth column 4M may be symmetric with respect to a virtual straight line ST. Such configuration may be repeated.

The plurality of first sub-pixels P1 may be spaced apart from each other on a first row 1N. For example, the plurality of first sub-pixels P1 may be spaced apart from each other in the first direction (e.g., the x direction). The third sub-pixel P3 may be arranged between the plurality of first sub-pixels P1 on the first row 1N. The plurality of second sub-pixels P2 may be spaced apart from each other in the first direction (e.g., the x direction) on a second row 2N adjacent to the first row 1N. For example, the plurality of second sub-pixels P2 may be spaced apart from each other in the first direction (e.g., the x direction). The third sub-pixel P3 may be arranged between the plurality of second sub-pixels P2 on the second row 2N. The plurality of second sub-pixels P2 may be spaced apart from each other on a third row 3N adjacent to the second row 2N. The third sub-pixel P3 may be arranged between the plurality of second sub-pixels P2 on the third row 3N. The plurality of first sub-pixels P1 may be spaced apart from each other in the first direction (e.g., the x direction) on a fourth row 4N adjacent to the third row 3N. The third sub-pixel P3 may be arranged between the plurality of first sub-pixels P1 on the fourth row 4N. Such configuration may be repeated.

The plurality of light-blocking lines 530 may extend in the first direction (e.g., the x direction). The plurality of light-blocking lines 530 may be spaced apart from each other with a first distance 530dis in the second direction (e.g., the y direction). The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm.

Each of the first width w1, the second width w2, and the third width w3 may be an integer multiple of the first distance 530dis. In an embodiment, the first width w1 may be substantially the same as the first distance 530dis. As an example, the first width w1 may be about 39 µm. The second width w2 may be about two times of the first distance 530dis. As an example, the second width w2 may be about 78 µm. The third width w3 may be about three times of the first distance 530dis. As an example, the third width w3 may be about 117 µm. In an embodiment, each of the first width w1, the second width w2, and the third width w3 may be an integer multiple of the first distance 530dis, and occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the edge of one of the plurality of first sub-pixels P1 to the edge of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the edge of one of the plurality of second sub-pixels P2 to the edge of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the edge of one of the plurality of third sub-pixels P3 to the edge of another of the plurality of third sub-pixels P3 in the second direction (e.g., the y direction). For example, occurrence of moire may be prevented or reduced.

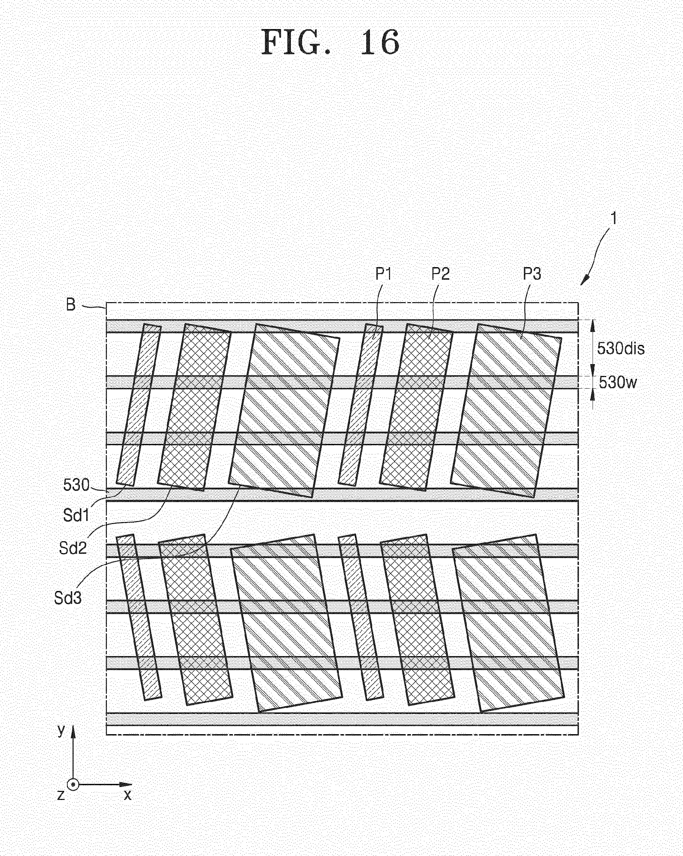

FIG. 16 is an enlarged view of a region B of the display apparatus 1 of FIG. 6 according to a comparative example.

Referring to FIG. 16, the display apparatus 1 according to a comparative example may include a first sub-pixel P1, a second sub-pixel P2, a third sub-pixel P3, and the plurality of light-blocking lines 530. In a comparative example, the first sub-pixel P1 may have a first side Sd1 extending with an inclination from the first direction (e.g., the x direction). The second sub-pixel P2 may have a second side Sd2 extending with an inclination from the first direction (e.g., the x direction). The third sub-pixel P3 may have a third side Sd3 extending with an inclination from the first direction (e.g., the x direction). For example, even though the first sub-pixel P1, the second sub-pixel P2, and the third sub-pixel P3 have a polygon shape (e.g., a parallelogram shape) in the display apparatus 1 according to a comparative example, moire may occur.

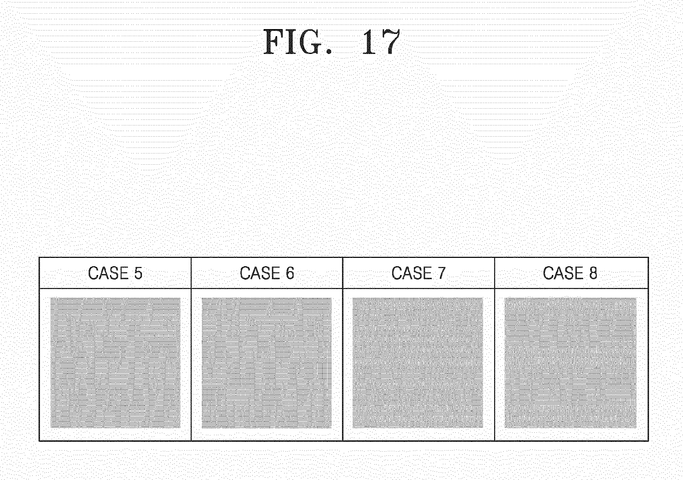

FIG. 17 is a table showing simulation results according to embodiments and simulation results according to a comparative example.

Referring to FIG. 17, CASE 5 is a simulation result of the embodiment described with reference to FIG. 14. CASE 6 is a simulation result of the embodiment described with reference to FIG. 15. CASE 7 is a simulation result of the comparative example described with reference to FIG. 16. CASE 8 is a simulation result of a comparative example in which each of the first width, the second width, and the third width is not an integer multiple of a first distance in the embodiment described with reference to FIG. 14. In CASE 8, each of the first width, the second width, and the third width is about 115 µm, and the first distance is about 39 µm. About 115 µm is a numerical value deviating from an integer multiple of about 39 µm by about 1.5% or more.

In CASE 5, it may be determined that moire does not occur. In CASE 5, brightness uniformity is 99.73, and just noticeable difference (JND) is 0.40.

In CASE 6, it may be determined that moire does not occur. In CASE 6, brightness uniformity is 99.68, and just noticeable difference (JND) is 0.46.

In CASE 7, it may be determined that moire does not occur. For example, a color moire has occurred in which color changed according to the position. In CASE 7, brightness uniformity is 98.57, and just noticeable difference (JND) is 2.15. In an embodiment, the first side of the first sub-pixel, the second side of the second sub-pixel, and the third side of the third sub-pixel may each extend in the first direction. In addition, each of the first width, the second width, and the third width may be an integer multiple of a first distance. For example, occurrence of moire may be prevented or reduced.

In CASE 8, it may be determined that moire does not occur. In CASE 8, brightness uniformity is 99.00, and just noticeable difference (JND) is 1.5. Accordingly, as in an embodiment, in the case where each of the first width, the second width, and the third width is an integer multiple of the first distance, occurrence of moire may be prevented or reduced.

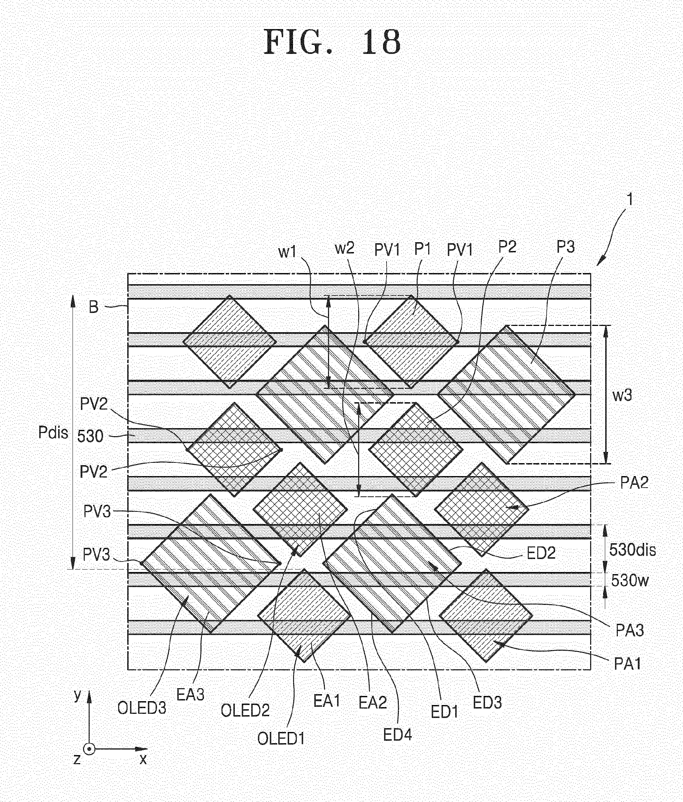

FIG. 18 is an enlarged view of the display apparatus 1 of FIG. 6 according to another example. In FIG. 18, the same reference numerals as those of FIG. 7 denote the same members, and thus, redundant descriptions thereof are omitted for descriptive convenience.

Referring to FIG. 18, the display apparatus 1 may include a first sub-pixel P1, a second sub-pixel P2, a third sub-pixel P3, and the plurality of light-blocking lines 530. The first sub-pixel P1 may have first vertexes PV1 spaced apart from each other in the first direction (e.g., the x direction). The first sub-pixel P1 may have a first width w1 in the second direction (e.g., the y direction) perpendicular to the first direction (e.g., the x direction). The first width w1 may be a maximum length of the first sub-pixel P1 in the second direction (e.g., the y direction) in a plan view. The first sub-pixel P1 may have a polygon shape (e.g., a parallelogram shape). In an embodiment, the first sub-pixel P1 may have a rhombus shape. The first sub-pixel P1 may be provided in plurality. For example, the first sub-pixel P1 may include a plurality of first sub-pixels P1. The plurality of first sub-pixels P1 may be spaced apart from each other in the first direction (e.g., the x direction).

The second sub-pixel P2 may have second vertexes PV2 spaced apart from each other in the first direction (e.g., the x direction). The second sub-pixel P2 may have a second width w2 extending in the second direction (e.g., the y direction). The second width w2 may be a maximum length of the second sub-pixel P2 in the second direction (e.g., the y direction) in a plan view. The second sub-pixel P2 may have a polygon shape (e.g., a parallelogram shape). In an embodiment, the second sub-pixel P2 may have a rhombus shape. The second sub-pixel P2 may be provided in plurality. For example, the second sub-pixel P2 may include a plurality of second sub-pixels P2. The plurality of second sub-pixels P2 may be spaced apart from each other in the first direction (e.g., the x direction).

The third sub-pixel P3 may have third vertexes PV3 spaced apart from each other in the first direction (e.g., the x direction). The third sub-pixel P3 may have a third width w3 extending in the second direction (e.g., the y direction). The third width w3 may be a maximum length of the third sub-pixel P3 in the second direction (e.g., the y direction) in a plan view. The third sub-pixel P3 may have a polygon shape (e.g., a parallelogram shape). In an embodiment, the third sub-pixel P3 may have a rhombus shape. The third sub-pixel P3 may be provided in plurality. For example, the third sub-pixel P3 may include a plurality of third sub-pixels P3. The plurality of third sub-pixels P3 may be spaced apart from each other in the first direction (e.g., the x direction).

The third sub-pixel P3 may include a first edge ED1, a second edge ED2, a third edge ED3, and a fourth edge ED4. In an embodiment, the second sub-pixel P2 may be disposed on one side of the first edge ED1. The second edge ED2 may be connected to the first edge ED1. The second sub-pixel P2 may be disposed on one side of the second edge ED2. The third edge ED3 may be connected to the second edge ED2. The first sub-pixel P1 may be disposed on one side of the third edge ED3. The fourth edge ED4 may be connected to each of the third edge ED3 and the first edge ED1. The first sub-pixel P1 may be disposed on one side of the fourth edge ED4.

An area PA2 of the second sub-pixel P2 may be about two times of an area PA1 of the first sub-pixel P1. An area PA3 of the third sub-pixel P3 may be about four times of the area PA1 of the first sub-pixel P1. A ratio of the area PA1 of the first sub-pixel P1, the area PA2 of the second sub-pixel P2, and the area PA3 of the third sub-pixel P3 may be about 1:2:4.

The plurality of light-blocking lines 530 may extend in the first direction (e.g., the x direction). The plurality of light-blocking lines 530 may be spaced apart from each other with a first distance 530dis (e.g., a constant distance) in the second direction (e.g., the y direction). The first distance 530dis may have the range of about 30 µm to about 60 µm. In an embodiment, the first distance 530dis may be about 39 µm. The width 530w of the light-blocking line 530 in the second direction (e.g., the y direction) may be about 10 µm.

Each of the first width w1, the second width w2, and the third width w3 may be an integer multiple of the first distance 530dis. For example, the integer multiple may be about two times or more. Each of the first width w1 and the second width w2 may be about two times of the first distance 530dis. The third width w3 may be about three times of the first distance 530dis. As an example, each of the first width w1 and the second width w2 may be about 78 µm. The third width w3 may be about 117 µm. For example, occurrence of moire may be prevented or reduced. Accordingly, the quality of the display apparatus 1 may be improved.

The plurality of first sub-pixels P1 may be spaced apart from each other, and a second distance Pdis with which the plurality of first sub-pixels P1 are spaced apart from each other in the second direction (e.g., the y direction) may not be an integer multiple of the first distance 530dis. The second distance Pdis with which the plurality of first sub-pixels P1 are spaced apart from each other in the second direction (e.g., the y direction) may be a distance from the vertex of one of the plurality of first sub-pixels P1 to the vertex of another of the plurality of first sub-pixels P1 in the second direction (e.g., the y direction). The plurality of second sub-pixels P2 may be spaced apart from each other, and a distance with which the plurality of second sub-pixels P2 are spaced apart from each other in the second direction (e.g., the y direction) may not be an integer multiple of the first distance 530dis. The distance with which the plurality of second sub-pixels P2 are spaced apart from each other in the second direction (e.g., the y direction) may be a distance from the vertex of one of the plurality of second sub-pixels P2 to the vertex of another of the plurality of second sub-pixels P2 in the second direction (e.g., the y direction). The plurality of third sub-pixels P3 may be spaced apart from each other, and a distance with which the plurality of third sub-pixels P3 are spaced apart from each other in the second direction (e.g., the y direction) may not be an integer multiple of the first distance 530dis. The distance with which the plurality of third sub-pixels P3 are spaced apart from each other in the second direction (e.g., the y direction) may be a distance from the vertex of one of the plurality of third sub-pixels P3 to the vertex of another of the plurality of third sub-pixels P3 in the second direction (e.g., the y direction). For example, occurrence of moire may be prevented or reduced.

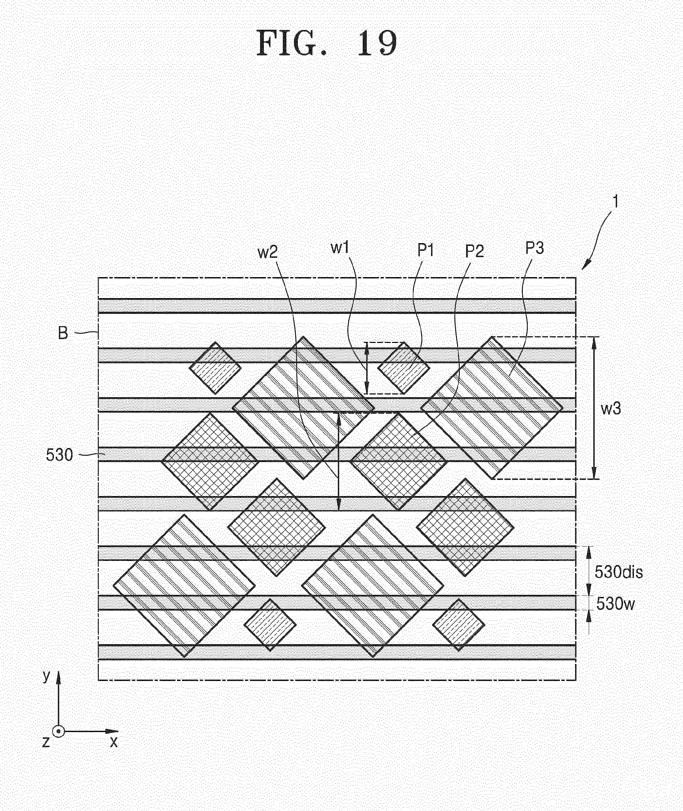

FIG. 19 is an enlarged view of a region B of the display apparatus 1 of FIG. 6 according to a comparative example. In FIG. 19, the same reference numerals as those of FIG. 18 denote the same members, and thus, redundant descriptions thereof are omitted for descriptive convenience.

Referring to FIG. 19, the first width w1 may be substantially the same as the first distance 530dis in the display apparatus 1 according to a comparative example. The second width w2 may be about two times of the first distance 530dis. The third width w3 may be about three times of the first distance 530dis. For example, moire may occur.

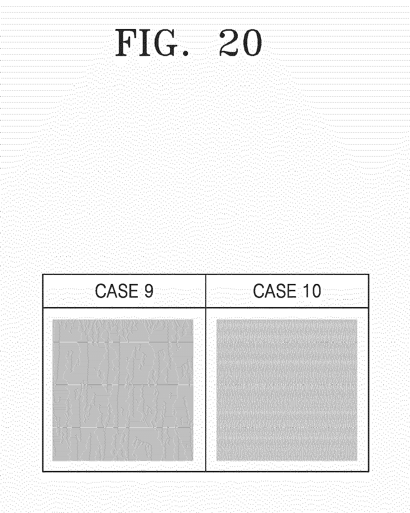

FIG. 20 is a table showing simulation results according to embodiments and simulation results according to a comparative example.

Referring to FIG. 20, CASE 9 is a simulation result of the embodiment described with reference to FIG. 18. CASE 10 is a simulation result of the comparative example described with reference to FIG. 19.

In CASE 9, it may be determined that moire does not occur. In CASE 9, brightness uniformity is 99.89, and just noticeable difference (JND) is 0.16.

In CASE 10, it may be determined that moire occurs. For example, a color moire has occurred in which color changed according to the position. In CASE 10, brightness uniformity is 97.05, and just noticeable difference (JND) is 4.48. In the case where the display apparatus 1 includes the first sub-pixel P1, the second sub-pixel P2, and the third sub-pixel P3 each having a rhombus shape, it may be determined that moire does not occur in case that each of the first width w1, the second width w2, and the third width w3 is an integer multiple of the first distance 530dis and the integer multiple is about two times or more.

As discussed, embodiments can provide a display apparatus comprising: a plurality of light-blocking lines extending in a first direction and spaced apart from each other with a first distance in a second direction perpendicular to the first direction, a first sub-pixel having a parallelogram shape including a first width in the second direction; a second sub-pixel having a parallelogram shape including a second width in the second direction; and a third sub-pixel having a parallelogram shape including a third width in the second direction; wherein each of the first width, the second width, and the third width is about an integer multiple of the first distance. Each of the first width, the second width, and the third width may be substantially an integer multiple of the first distance.

In some embodiments, the first sub-pixel includes a first side extending in the first direction, the second sub-pixel includes a second side extending in the first direction, and the third sub-pixel includes a third side extending in the first direction.

In some embodiments, the first sub-pixel includes a first side extending in a direction inclined to the first direction, the second sub-pixel includes a second side extending in a direction inclined to the first direction, and the third sub-pixel includes a third side extending in a direction inclined to the first direction. The inclined first, second and third sides of the first, second, and third sub-pixels may be parallel.

In some embodiments, the first sub-pixel includes a side extending in the second direction, the second sub-pixel includes a side extending in the second direction, and the third sub-pixel includes a side extending in the second direction.

In some embodiments, the first sub-pixel includes a side extending in a direction inclined to the second direction, the second sub-pixel includes a side extending in a direction inclined to the second direction, and the third sub-pixel includes a side extending in a direction inclined to the second direction. The inclined sides of the first, second, and third sub-pixels may be parallel.

In some embodiments, first sub-pixel has a rhombus shape having vertexes spaced apart from each other in the first direction; the second sub-pixel has a rhombus shape having vertexes spaced apart from each other in the first direction; and the third sub-pixel has a rhombus shape having vertexes spaced apart from each other in the first direction; and the integer multiple is 2 or more.

In any of the above-discussed embodiments, the width of a sub-pixel may be a maximum length of that sub-pixel in the second direction in a plan view.

The first sub-pixel, the second sub-pixel, and the third sub-pixel may be sequentially arranged in the first direction.

Embodiments can also provide a vehicle comprising: a display apparatus according to any one of the discussed embodiments; and side window glasses spaced apart from each other in the first direction; where the display apparatus is disposed between the side window glasses.

As described above, the display apparatus according to an embodiment may include the first sub-pixel P1, the second sub-pixel P2, the third sub-pixel P3, and the plurality of light-blocking lines spaced apart from each other with the first distance and extending in the first direction. The first width of the first sub-pixel, the second width of the second sub-pixel, and the third width of the third sub-pixel may be an integer multiple of the first distance of the plurality of light-blocking lines. Accordingly, light emitted from the display apparatus according to an embodiment may transmit in various directions (e.g., a specific direction), and the display quality may be improved.

The vehicle according to an embodiment may include the display apparatus, and a phenomenon that a driver's view is hindered by light emitted from the display apparatus may be prevented or reduced.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a plurality of light-blocking lines extending in a first direction and spaced apart from each other with a first distance in a second direction perpendicular to the first direction,
a first sub-pixel having a parallelogram shape including a first width in the second direction;
a second sub-pixel having a parallelogram shape including a second width in the second direction; and
a third sub-pixel having a parallelogram shape including a third width in the second direction;
wherein
each of the first width, the second width, and the third width is about an integer multiple of the first distance.

2. The display apparatus of claim 1, wherein the first sub-pixel includes a first side extending in the first direction, the second sub-pixel includes a second side extending in the first direction, and the third sub-pixel includes a third side extending in the first direction.

3. The display apparatus of claim 1, wherein the first sub-pixel includes a first side extending in a direction inclined to the first direction, the second sub-pixel includes a second side extending in a direction inclined to the first direction, and the third sub-pixel includes a third side extending in a direction inclined to the first direction.

4. The display apparatus of claim 1 or 2, wherein the first sub-pixel includes a side extending in the second direction, the second sub-pixel includes a side extending in the second direction, and the third sub-pixel includes a side extending in the second direction.

5. The display apparatus of claim 1 or 2, wherein the first sub-pixel includes a side extending in a direction inclined to the second direction, the second sub-pixel includes a side extending in a direction inclined to the second direction, and the third sub-pixel includes a side extending in a direction inclined to the second direction.

6. The display apparatus of claim 1, wherein:
the first sub-pixel has a rhombus shape having vertexes spaced apart from each other in the first direction;
the second sub-pixel has a rhombus shape having vertexes spaced apart from each other in the first direction;
the third sub-pixel has a rhombus shape having vertexes spaced apart from each other in the first direction; and
the integer multiple is 2 or more.

7. The display apparatus of any one of claims 1 to 5, wherein each of the first width, the second width, and the third width is about three times of the first distance.

8. The display apparatus of any one of claims 1 to 5, wherein
the first width is substantially equal to the first distance,
the second width is about two times of the first distance, and
the third width is about three times of the first distance.

9. The display apparatus of claim 2, further comprising:
a fourth sub-pixel having a parallelogram shape including a fourth side extending in the first direction and a fourth width in the second direction, wherein
each of the first width and the third width is substantially equal to the first distance,
each of the second width and the fourth width is about two times of the first distance,
the first sub-pixel emits light in a red wavelength band,
the second sub-pixel emits light in a green wavelength band, and
each of the third sub-pixel and the fourth sub-pixel emits light in a blue wavelength band.

10. The display apparatus of any one of claims 1 to 5, wherein
an area of the second sub-pixel is about 2.8 times of an area of the first sub-pixel, and
an area of the third sub-pixel is about 5.4 times of the area of the first sub-pixel.

11. The display apparatus of claim 1 or 2, wherein each of the first sub-pixel, the second sub-pixel, and the third sub-pixel has a rectangular shape.

12. The display apparatus of any one of claims 1 to 10, further comprising:
a substrate including a display area and a non-display area;
a display layer disposed in the display area and including a first organic light-emitting diode, a second organic light-emitting diode, and a third organic light-emitting diode, the first organic light-emitting diode including a first emission area corresponding to the first sub-pixel, the second organic light-emitting diode including a second emission area corresponding to the second sub-pixel, the third organic light-emitting diode including a third emission area corresponding to the third sub-pixel;
an encapsulation member covering the display layer;
an anti-reflection layer on the encapsulation member; and
a light path-controlling layer on the anti-reflection layer and including the plurality of light-blocking lines;
optionally wherein the encapsulation member includes an encapsulation layer including at least one inorganic encapsulation layer and at least one organic encapsulation layer that are alternately stacked.

13. The display apparatus of any one of claims 1 to 12, wherein
the first sub-pixel includes a plurality of first sub-pixels spaced apart from each other, and
a second distance at which the plurality of first sub-pixels are disposed in the second direction is not an integer multiple of the first distance.

14. The display apparatus of any one of claims 1 to 13, wherein the first sub-pixel, the second sub-pixel, and the third sub-pixel are sequentially arranged in the first direction.

15. A vehicle comprising:
a display apparatus according to any one of claims 1 to 14; and
side window glasses spaced apart from each other in the first direction;
where the display apparatus is disposed between the side window glasses.
